(19) Europäisches Patentamt / European Patent Office / Office européen des brevets

(11) EP 4 671 307 A1

(12) **EUROPEAN PATENT APPLICATION**
published in accordance with Art. 153(4) EPC

(43) Date of publication:
**31.12.2025 Bulletin 2026/01**

(21) Application number: **25765938.3**

(22) Date of filing: **22.04.2025**

(51) International Patent Classification (IPC):
***C08G 73/10*** *(2006.01)* ***B32B 15/088*** *(2006.01)*
***H05K 1/03*** *(2006.01)*

(52) Cooperative Patent Classification (CPC):
**B32B 15/088; C08G 73/10; C08J 5/18; H05K 1/03**

(86) International application number:
**PCT/JP2025/015593**

(87) International publication number:
**WO 2025/225613 (30.10.2025 Gazette 2025/44)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **24.04.2024 JP 2024070590**

(71) Applicants:
- **DAIKIN INDUSTRIES, LTD.**
  **Osaka-Shi, Osaka 530-0001 (JP)**
- **The University Of Tokyo**
  **Tokyo 113-8654 (JP)**

(72) Inventors:
- **YOSHIZAKI, Satoru**
  **Osaka-Shi**
  **Osaka**
  **5300001 (JP)**
- **MIZUTANI, Seigo**
  **Osaka-Shi**
  **Osaka**
  **5300001 (JP)**
- **YONEDA, Satoru**
  **Osaka-Shi**
  **Osaka**
  **5300001 (JP)**
- **SEKI, Toyomitsu**
  **Osaka-Shi**
  **Osaka**
  **5300001 (JP)**
- **HIGASHI, Masahiro**
  **Osaka-Shi**
  **Osaka**
  **5300001 (JP)**
- **KISHIKAWA, Yosuke**
  **Osaka-Shi**
  **Osaka**
  **5300001 (JP)**
- **SHIGEMOTO, Isamu**
  **Osaka-Shi**
  **Osaka**
  **5300001 (JP)**
- **SAGISAKA, Shigehito**
  **Osaka-Shi**
  **Osaka**
  **5300001 (JP)**
- **SHIOMI, Junichiro**
  **Tokyo**
  **1138654 (JP)**
- **OHNISHI, Masato**
  **Tokyo**
  **1138654 (JP)**

(74) Representative: **Hoffmann Eitle**
**Patent- und Rechtsanwälte PartmbB**
**Arabellastraße 30**
**81925 München (DE)**

# (54) POLYIMIDE RESIN FOR SUBSTRATE MATERIAL, COMPOSITION, POLYIMIDE FILM, LAMINATE, SUBSTRATE FOR CIRCUIT, ANTENNA, POLYAMIC ACID FOR SUBSTRATE MATERIAL, AND COMPOSITION

(57) A polyimide resin for a substrate material includes an acid anhydride and a diamine. The acid anhydride is one or more selected from the group consisting of compounds represented by general formula (A-1a) below, and the diamine is one or more selected from the group consisting of compounds represented by general formula (B-1) below and compounds represented by general formula (B-2) below:

[Chem. 1]

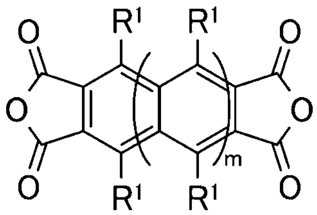

A-1a

[Chem. 2]

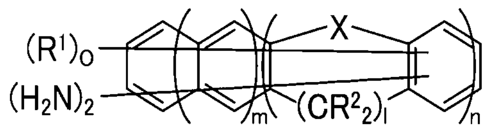

B-1

and

[Chem. 3]

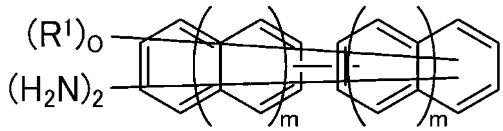

B-2

.

## Description

### TECHNICAL FIELD

The present disclosure relates to a polyimide resin for a substrate material, a composition, a polyimide film, a laminate, a substrate for a circuit, and an antenna, as well as a polyamic acid for a substrate material and a composition.

### BACKGROUND ART

Substrates for electronic components have been increasingly changed from glass substrates to resin substrates. For such resin substrates, a material excellent in heat resistance, electrical insulation, and dimensional stability is required.

There have been reports on polyimide substrates for electronic components that are soluble in specific organic solvents, are readily molded, are low in thermal expansion coefficient (linear expansion coefficient), and excellent in dimensional stability (see, for example, Patent Literature 1). However, a low dielectric constant and a low linear expansion coefficient are generally in a trade-off relationship, and thus it has been challenging to satisfactorily achieve both at the same time.

### CITATION LIST

### PATENT LITERATURE

Patent Literature 1: Japanese Laid-Open Patent Application No. 2019-196459

### SUMMARY OF THE INVENTION

### TECHNICAL PROBLEM

It is an object of the present disclosure to provide a polyimide resin for a substrate material that has both a low dielectric constant and a low linear expansion coefficient.

### SOLUTION TO THE PROBLEM

<1> A polyimide resin for a substrate material, the polyimide resin including:

an acid anhydride; and
a diamine, wherein
the acid anhydride is one or more selected from the group consisting of compounds represented by general formula (A-1a) below, and
the diamine is one or more selected from the group consisting of compounds represented by general formula (B-1) below and compounds represented by general formula (B-2) below:

[Chem. 1]

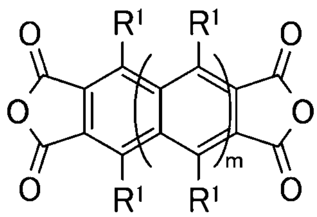

A-1a

in the general formula (A-1a),

$R^1$ is each independently selected from the group consisting of hydrogen, halogens, optionally substituted alkyl groups, optionally substituted aromatic rings, and optionally substituted heterocyclic rings,
at least one $R^1$ includes a fluorine atom, and
m represents an integer of 0 to 3,

[Chem. 2]

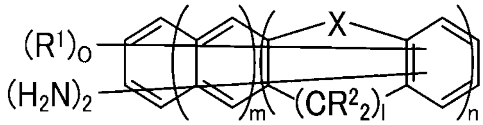

B-1

in the general formula (B-1),

$R^1$ is each independently selected from the group consisting of hydrogen, halogens, optionally substituted alkyl groups, optionally substituted alkoxy groups, optionally substituted aromatic rings, and optionally substituted heterocyclic rings,
l represents an integer of 1 to 3,
m represents an integer of 0 to 3,
n represents an integer of 0 to 5,
o represents an integer of 0 to a maximum substituent number,
$R^2$ is each independently selected from the group consisting of hydrogen, halogens, optionally substituted alkyl groups, optionally substituted aromatic rings, and optionally substituted heterocyclic rings, where two neighboring $R^2$ are optionally bonded to form a cycloalkyl group,
at least one $R^2$ is an optionally substituted fluoroalkyl group,
X is each independently selected from the group consisting of -O-, $-C(R^3)_2-$, and $-SO_2-$, and
$R^3$ is each independently selected from the group consisting of hydrogen, halogens, optionally substituted alkyl groups, optionally substituted aromatic rings, and optionally substituted heterocyclic rings, where two neighboring $R^3$ are optionally bonded to form a cycloalkyl group, and

[Chem. 3]

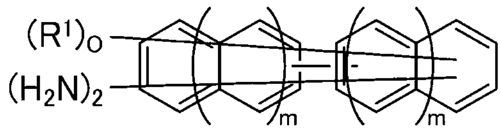

B-2

in the general formula (B-2),

$R^1$ is each independently selected from the group consisting of hydrogen, halogens, optionally substituted alkyl groups, optionally substituted alkoxy groups, optionally substituted aromatic rings, and optionally substituted heterocyclic rings,
at least one $R^1$ includes a fluorine atom,
m each independently represents an integer of 0 to 2, and
o represents an integer of 0 to a maximum substituent number.

<2> The polyimide resin according to <1> above, wherein

the general formula (B-1) is general formula (B-1a) below or general formula (B-1b) below, and
the general formula (B-2) is general formula (B-2a) below:

[Chem. 4]

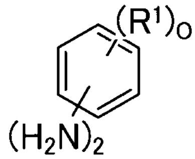

B-1a

in the general formula (B-1a),

$R^1$ is each independently selected from the group consisting of hydrogen, halogens, optionally substituted alkyl groups, optionally substituted alkoxy groups, optionally substituted aromatic rings, and optionally substituted heterocyclic rings, and
o represents an integer of 0 to 4,

[Chem. 5]

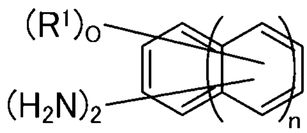

B-1b

in the general formula (B-1b),

$R^1$ is each independently selected from the group consisting of hydrogen, halogens, optionally substituted alkyl groups, optionally substituted alkoxy groups, optionally substituted aromatic rings, and optionally substituted heterocyclic rings,
m represents an integer of 1 to 3, and
o represents an integer of 0 to a maximum substituent number, and

[Chem. 6]

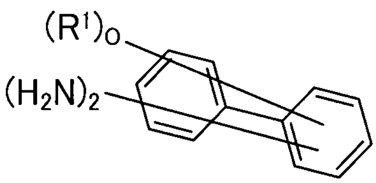

B-2a

in the general formula (B-2a),

$R^1$ is each independently selected from the group consisting of hydrogen, halogens, optionally substituted alkyl groups, optionally substituted alkoxy groups, optionally substituted aromatic rings, and optionally substituted heterocyclic rings,
at least one $R^1$ includes a fluorine atom, and
o represents an integer of 0 to 8.

<3> A polyimide resin for a substrate material, the polyimide resin including:

an acid anhydride; and
a diamine, wherein
the acid anhydride is one or more selected from the group consisting of compounds represented by general formula (A-2a) to general formula (A-2g) below, and
the diamine is one or more selected from the group consisting of compounds represented by general formula (B-3) below and compounds represented by general formula (B-4) below:

[Chem. 7]

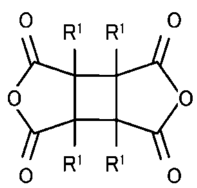
A-2a

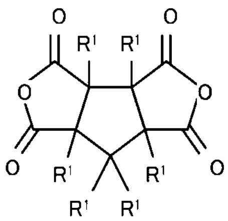
A-2b

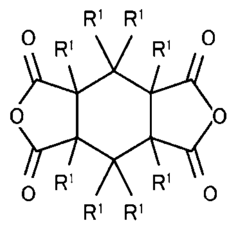
A-2c

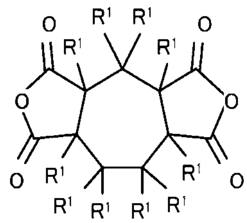
A-2d

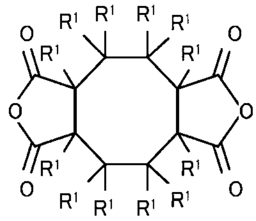
A-2e

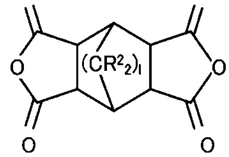
A-2f

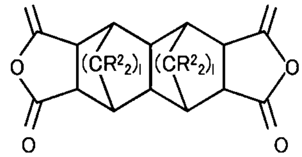
A-2g

in the general formula (A-2a) to the general formula (A-2g),

$R^1$ is each independently selected from the group consisting of hydrogen, halogens, optionally substituted alkyl groups, optionally substituted alkoxy groups, optionally substituted aromatic rings, and optionally substituted heterocyclic rings,
l represents an integer of 1 to 3, and
$R^2$ is each independently selected from the group consisting of hydrogen, halogens, optionally substituted alkyl groups, optionally substituted alkoxy groups, optionally substituted aromatic rings, and optionally substituted heterocyclic rings,

[Chem. 8]

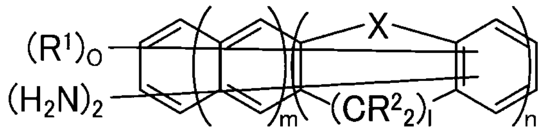

B-3

in the general formula (B-3),

$R^1$ is each independently selected from the group consisting of hydrogen, halogens, optionally substituted alkyl groups, optionally substituted alkoxy groups, optionally substituted aromatic rings, and optionally substituted heterocyclic rings,
l represents an integer of 1 to 3,
m represents an integer of 0 to 3,
n represents an integer of 0 to 5,
o represents an integer of 0 to a maximum substituent number,
$R^2$ is each independently selected from the group consisting of hydrogen, halogens, optionally substituted alkyl groups, optionally substituted aromatic rings, and optionally substituted heterocyclic rings,
at least one $R^2$ is an optionally substituted fluoroalkyl group,
X is each independently selected from the group consisting of -O-, $-C(R^3)_2-$, and $-SO_2-$, and
$R^3$ is each independently selected from the group consisting of hydrogen, halogens, optionally substituted alkyl groups, optionally substituted aromatic rings, and optionally substituted heterocyclic rings, where two neighboring $R^3$ are optionally bonded to form a cycloalkyl group,

[Chem. 9]

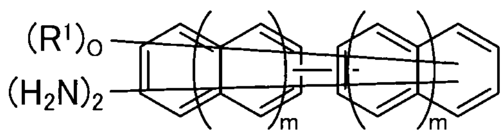

B-4

in the general formula (B-4),

$R^1$ is each independently selected from the group consisting of hydrogen, halogens, optionally substituted alkyl groups, optionally substituted alkoxy groups, optionally substituted aromatic rings, and optionally substituted heterocyclic rings,
m each independently represents an integer of 0 to 2, and
o represents an integer of 0 to a maximum substituent number.

<4> The polyimide resin according to <3> above, wherein

the general formula (B-3) is general formula (B-3a) below or general formula (B-3b) below, and
the general formula (B-4) is general formula (B-4a) below:

[Chem. 10]

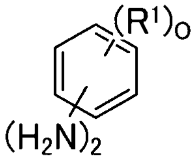

B-3a

in the general formula (B-3a),

$R^1$ is each independently selected from the group consisting of hydrogen, halogens, optionally substituted alkyl groups, optionally substituted alkoxy groups, optionally substituted aromatic rings, and optionally substituted heterocyclic rings, and
o represents an integer of 0 to 4,

[Chem. 11]

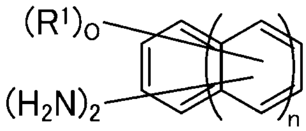

B-3b

in the general formula (B-3b),

$R^1$ is each independently selected from the group consisting of hydrogen, halogens, optionally substituted alkyl groups, optionally substituted alkoxy groups, optionally substituted aromatic rings, and optionally substituted heterocyclic rings,
m represents an integer of 1 to 3, and
o represents an integer of 0 to a maximum substituent number, and

[Chem. 12]

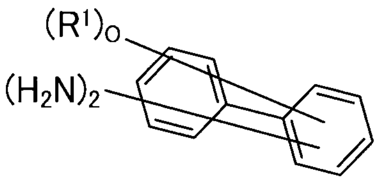

B-4a

in the general formula (B-4a),

$R^1$ is each independently selected from the group consisting of hydrogen, halogens, optionally substituted alkyl groups, optionally substituted alkoxy groups, optionally substituted aromatic rings, and optionally substituted heterocyclic rings,
at least one $R^1$ includes a fluorine atom, and
o represents an integer of 0 to 8.

<5> The polyimide resin according to any one of <1> to <4> above, wherein

a dielectric constant at 10 GHz of the polyimide resin is 2.5 or less, and
a linear expansion coefficient of the polyimide resin is 40 ppm/K or less.

<6> A polyimide resin for a substrate material, the polyimide resin including:

a structural unit of general formula (1) below:

[Chem. 13]

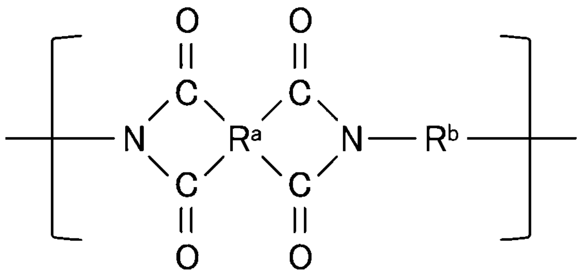

General Formula (1)

in the general formula (1),

an $R^a(CO)_4$ moiety represents a tetravalent group derived from a tetravalent tetracarboxylic acid having 2 or more carbon atoms, and
an $R^b(N)_2$ moiety represents a tetravalent group derived from a divalent diamine having 2 or more carbon atoms, wherein

a free volume fraction and an average neighboring atom number of the polyimide resin in an amorphous state that are calculated through molecular dynamics calculation in an equilibrium state in which a temperature is 300 K and a pressure is 1 atm, satisfy condition (1) below:

(1) the free volume fraction is 0.23 to 0.32 and the average neighboring atom number is 3.90 to 4.60, and no trifluoromethyl group is included,

the average neighboring atom number is an average of a number of neighboring atoms per a number of atoms constituting a system of the molecular dynamics calculation, and
the number of neighboring atoms is a total number of atom pairs satisfying (a) and (b) below:

(a) the atom pairs each have one shared side of Voronoi cells in which the atoms are sites, and
(b) the atom pairs are each a pair of atoms 4 bonds or more away from each other, or a pair of atoms existing in different molecules.

<7> The polyimide resin according to <6> above, wherein

the free volume fraction is 0.24 to 0.32, and the average neighboring atom number is 3.90 to 4.50, and
the polyimide resin includes no trifluoromethyl group.

<8> The polyimide resin according to <6> above, wherein

the free volume fraction is 0.28 to 0.32, and the average neighboring atom number is 3.90 to 4.50, and

the polyimide resin includes no trifluoromethyl group.

<9> The polyimide resin according to any one of <1> to <8> above, wherein

a free volume fraction and an average neighboring atom number of the polyimide resin in an amorphous state that are calculated through molecular dynamics calculation in an equilibrium state in which a temperature is 300 K and a pressure is 1 atm, satisfy condition (1):

(1) the free volume fraction is 0.23 to 0.32 and the average neighboring atom number is 3.90 to 4.60, and no trifluoromethyl group is included, the average neighboring atom number is an average of a number of neighboring atoms per a number of atoms constituting a system of the molecular dynamics calculation, and

the number of neighboring atoms is a total number of atom pairs satisfying (a) and (b) below:

(a) the atom pairs each have one shared side of Voronoi cells in which the atoms are sites, and
(b) the atom pairs are each a pair of atoms 4 bonds or more away from each other, or a pair of atoms existing in different molecules.

<10> A composition for a substrate material, the composition including:
the polyimide resin of any one of <1> to <9> above.
<11> A polyimide film for a substrate material, the polyimide film including:
the polyimide resin of any one of <1> to <9> above.
<12> A laminate, including:

a metal layer; and
a layer including the polyimide resin of any one of <1> to <9> above.

<13> A substrate for a circuit, the substrate including:
the laminate of <12> above.
<14> An antenna, including:
the substrate for the circuit of <13> above.
<15> A polyamic acid for a substrate material, the polyamic acid including:

an acid anhydride; and
a diamine, wherein
the acid anhydride is one or more selected from the group consisting of compounds represented by general formula (A-1a) below, and
the diamine is one or more selected from the group consisting of compounds represented by general formula (B-1) below and compounds represented by general formula (B-2) below:

[Chem. 14]

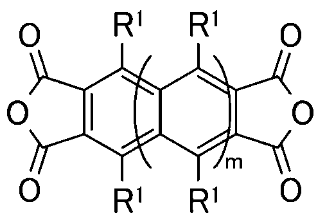

A-1a

in the general formula (A-1a),

$R^1$ is each independently selected from the group consisting of hydrogen, halogens, optionally substituted alkyl groups, optionally substituted aromatic rings, and optionally substituted heterocyclic rings,
at least one $R^1$ includes a fluorine atom, and
m represents an integer of 0 to 3,

[Chem. 15]

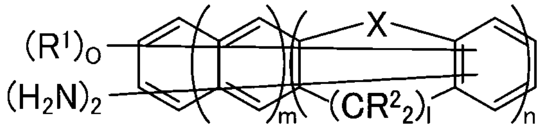

B-1

in the general formula (B-1),

$R^1$ is each independently selected from the group consisting of hydrogen, halogens, optionally substituted alkyl groups, optionally substituted aromatic rings, and optionally substituted heterocyclic rings,
l represents an integer of 1 to 3,
m represents an integer of 0 to 3,
n represents an integer of 0 to 5,
o represents an integer of 0 to a maximum substituent number,
$R^2$ is each independently selected from the group consisting of hydrogen, halogens, optionally substituted alkyl groups, optionally substituted aromatic rings, and optionally substituted heterocyclic rings, where two neighboring $R^2$ are optionally bonded to form a cycloalkyl group,
at least one $R^2$ is an optionally substituted fluoroalkyl group,
X is each independently selected from the group consisting of -O-, $-C(R^3)_2-$, and $-SO_2-$, and
$R^3$ is each independently selected from the group consisting of hydrogen, halogens, optionally substituted alkyl groups, optionally substituted aromatic rings, and optionally substituted heterocyclic rings, where two neighboring $R^3$ are optionally bonded to form a cycloalkyl group, and

[Chem. 16]

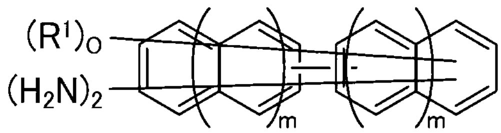

B-2

in the general formula (B-2),

$R^1$ is each independently selected from the group consisting of hydrogen, halogens, optionally substituted alkyl groups, optionally substituted aromatic rings, and optionally substituted heterocyclic rings,
at least one $R^1$ includes a fluorine atom,
m each independently represents an integer of 0 to 2, and
o represents an integer of 0 to a maximum substituent number.

<16> A polyamic acid for a substrate material, the polyamic acid including:

an acid anhydride; and
a diamine, wherein
the acid anhydride is one or more selected from the group consisting of compounds represented by general formula (A-2a) to general formula (A-2g) below, and
the diamine is one or more selected from the group consisting of compounds represented by general formula (B-3) below and compounds represented by general formula (B-4) below:

[Chem. 17]

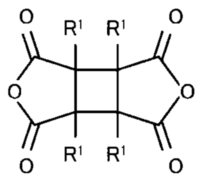

A-2a

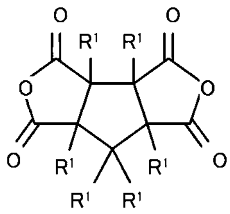

A-2b

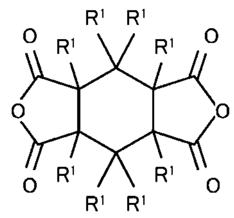

A-2c

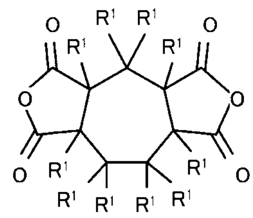

A-2d

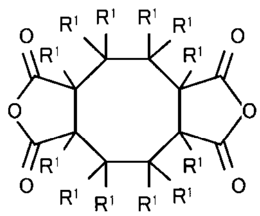

A-2e

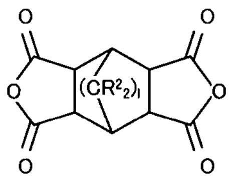

A-2f

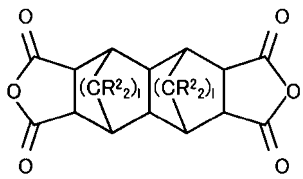

A-2g

in the general formula (A-2a) to the general formula (A-2g),

$R^1$ is each independently selected from the group consisting of hydrogen, halogens, optionally substituted alkyl groups, optionally substituted alkoxy groups, optionally substituted aromatic rings, and optionally substituted heterocyclic rings,
l represents an integer of 1 to 3, and
$R^2$ is each independently selected from the group consisting of hydrogen, halogens, optionally substituted alkyl groups, optionally substituted alkoxy groups, optionally substituted aromatic rings, and optionally substituted heterocyclic rings,

[Chem. 18]

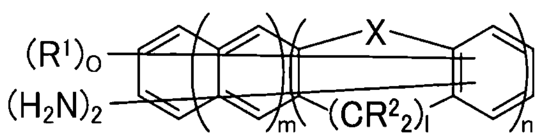

B-3

in the general formula (B-3),

$R^1$ is each independently selected from the group consisting of hydrogen, halogens, optionally substituted alkyl groups, optionally substituted alkoxy groups, optionally substituted aromatic rings, and optionally substituted heterocyclic rings,
l represents an integer of 1 to 3,

m represents an integer of 0 to 3,
n represents an integer of 0 to 5,
o represents an integer of 0 to a maximum substituent number,
$R^2$ is each independently selected from the group consisting of hydrogen, halogens, optionally substituted alkyl groups, optionally substituted aromatic rings, and optionally substituted heterocyclic rings, at least one $R^2$ is an optionally substituted fluoroalkyl group,
X is each independently selected from the group consisting of -O-, -C($R^3$)$_2$-, and -$SO_2$-, and
$R^3$ is each independently selected from the group consisting of hydrogen, halogens, optionally substituted alkyl groups, optionally substituted aromatic rings, and optionally substituted heterocyclic rings, where two neighboring $R^3$ are optionally bonded to form a cycloalkyl group, and

[Chem. 19]

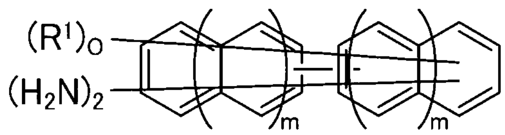

B-4

in the general formula (B-4),

$R^1$ is each independently selected from the group consisting of hydrogen, halogens, optionally substituted alkyl groups, optionally substituted alkoxy groups, optionally substituted aromatic rings, and optionally substituted heterocyclic rings,
m each independently represents an integer of 0 to 2, and
o represents an integer of 0 to a maximum substituent number.

<17> A composition for a substrate material, the composition including:

the polyamic acid of <15> or <16>; and
a solvent.

ADVANTAGEOUS EFFECTS OF THE INVENTION

According to the present disclosure, it is possible to provide a polyimide resin for a substrate material that has both a low dielectric constant and a low linear expansion coefficient.

BRIEF DESCRIPTION OF THE DRAWINGS

[FIG. 1] FIG. 1 is a cross-sectional view illustrating an example of a laminate of the present embodiment.
[FIG. 2] FIG. 2 is a cross-sectional view illustrating another example of the laminate of the present embodiment.
[FIG. 3] FIG. 3 is a graph in which free volume fractions and average neighboring atom numbers in molecular dynamics simulation of Examples are plotted.
[FIG. 4] FIG. 4 is a graph in which measured values of a dielectric constant and measured values of a linear expansion coefficient are plotted.
[FIG. 5] FIG. 5 is a graph indicating a relationship between experimental values and calculated values in the molecular dynamics simulation for the dielectric constant at a frequency of 10 GHz.
[FIG. 6] FIG. 6 is a graph indicating a relationship between experimental values and calculated values in the molecular dynamics simulation for the linear expansion coefficient.

DESCRIPTION OF THE EMBODIMENTS

(Polyimide Resin for Substrate Material)

The polyimide resin for the substrate material of the present disclosure is a polyimide resin that is used for applications as materials for substrates, e.g., a low-dielectric-constant insulating member of circuit substrates, and has both a low dielectric constant and a low linear expansion coefficient. The polyimide resin of the present disclosure is a polyimide resin (1) having a specific chemical structure in a first embodiment, (2) having a specific chemical structure in a second embodiment, (3) satisfying definitions of the free volume fraction and the average neighboring atom number in a third embodiment, or (4) satisfying (1) or (2) above and (3) above.

Preferably, a dielectric constant at 10 GHz of the polyimide resin is 2.5 or less, and a linear expansion coefficient of the polyimide resin is 40 ppm/K or less.

The polyimide resin for the substrate material of the present disclosure is based on the following finding obtained by the present inventors.

Specifically, a low dielectric constant and a low linear expansion coefficient are generally in a trade-off relationship, and it has been challenging to satisfactorily achieve both at the same time. As demonstrated in Examples described below, the present inventors specified two different parameters, i.e., "free volume fraction" and newly set "average neighboring atom number", through molecular dynamics simulation using a polyimide resin in an amorphous state, and have found that these two parameters are correlated with calculated values of a dielectric constant and a linear expansion coefficient. In addition, as a result of evaluating relationships with experimental values of a dielectric constant and a linear expansion coefficient in a large number of publicly known polyimide resins, the present inventors have found that a high level of "free volume fraction" contributes to a low dielectric constant and a low linear expansion coefficient, and a low level of "average neighboring atom number" contributes to a low dielectric constant.

Therefore, the present inventors have found that it is possible to determine a polyimide resin having both a low dielectric constant and a low linear expansion coefficient based on the free volume fraction and the average neighboring atom number serving as indices. Further, the present inventors have determined chemical structures of a polyimide resin having both a low dielectric constant and a low linear expansion coefficient through the molecular dynamics simulation.

[First Embodiment]

The polyimide resin for the substrate material in the first embodiment of the present disclosure is a polyimide resin including an acid anhydride and a diamine. The acid anhydride is one or more selected from the group consisting of compounds represented by general formula (A-1a) below, and the diamine is one or more selected from the group consisting of compounds represented by general formula (B-1) below and compounds represented by general formula (B-2) below.

<Acid Anhydride>

The acid anhydride is one or more selected from the group consisting of compounds represented by general formula (A-1a) below.

The acid anhydrides may be used alone or in combination.

[Chem. 20]

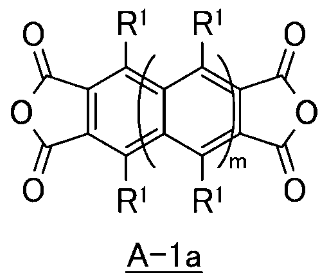

A-1a

In the general formula (A-1a), $R^1$ is each independently selected from the group consisting of hydrogen, halogens, optionally substituted alkyl groups, optionally substituted aromatic rings, and optionally substituted heterocyclic rings, and at least one $R^1$ includes a fluorine atom.

The substituent may be any group having a structure that can substitute a target. Examples of such a group include one or more selected from the group consisting of halogens, a hydroxy group, alkoxy groups, alkylcarbonyl groups, alkylcarbonyloxy groups, alkoxycarbonyl groups, arylcarbonyloxy groups, aryloxycarbonyl groups, and aryl groups.

The number of substituents can be selected from integers (e.g., 1, 2, 3, and the like) in the range of 1 to the maximum possible number of substituents (hereinafter referred to as "maximum substituent number").
Preferably, one of the $R^1$ is fluorine, and the other $R^1$ are each independently selected from the group consisting of hydrogen, fluorine, and alkyl groups having 1 to 4 carbon atoms; and more preferably, one of the $R^1$ is fluorine, and the other $R^1$ are each independently selected from the group consisting of hydrogen, fluorine, and a methyl group.
In the general formula (A-1a), m represents an integer of 0 to 3, preferably 0, 1, or 2, and more preferably 0 or 1.

<Diamine>

The diamine is one or more selected from the group consisting of compounds represented by general formula (B-1) below and compounds represented by general formula (B-2) below.
In one embodiment, the general formula (B-1) is preferably general formula (B-1a) below or general formula (B-1b) below, and the general formula (B-2) is preferably general formula (B-2a) below.
The diamines may be used alone or in combination.

[Chem. 21]

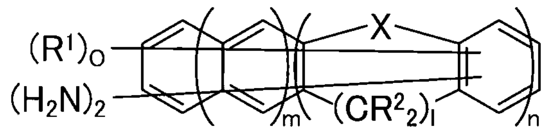

B-1

In the general formula (B-1), $R^1$ is each independently selected from the group consisting of hydrogen, halogens, optionally substituted alkyl groups, optionally substituted alkoxy groups, optionally substituted aromatic rings, and optionally substituted heterocyclic rings.
The matters described for the substituent in the $R^1$ in the general formula (A-1) are appropriately applicable to the substituent in the $R^1$ in the general formula (B-1).
The $R^1$ is preferably each independently selected from the group consisting of hydrogen, fluorine, and alkyl groups having 1 to 4 carbon atoms, and is more preferably each independently selected from the group consisting of hydrogen, fluorine, and a methyl group.
In the general formula (B-1), l represents an integer of 1 to 3, preferably 1 or 2, and more preferably 1.
m represents an integer of 0 to 3, preferably 0, 1, or 2, and more preferably 0 or 1.
n represents an integer of 0 to 5, preferably an integer of 0 to 3, and more preferably 0 or 1.
o represents an integer of 0 to the maximum substituent number, preferably an integer corresponding to 25% or more of the maximum substituent number, and more preferably an integer corresponding to 50% or more of the maximum substituent number.
In the general formula (B-1), $R^2$ is each independently selected from the group consisting of hydrogen, halogens, optionally substituted alkyl groups, optionally substituted aromatic rings, and optionally substituted heterocyclic rings. Two neighboring $R^2$ are optionally bonded to form a cycloalkyl group. At least one $R^2$ is an optionally substituted fluoroalkyl group.
The matters described for the substituent in the $R^1$ in the general formula (A-1) are appropriately applicable to the substituent in the $R^2$ in the general formula (B-1). Preferably, the substituent in the $R^2$ in the general formula (B-1) is a halogen other than fluorine, or an alkyl group having 1 to 4 carbon atoms.
Preferably, one of the $R^2$ is a fluoroalkyl group having 1 to 4 carbon atoms, and the other $R^2$ are each independently selected from the group consisting of hydrogen, alkyl groups having 1 to 4 carbon atoms, and aromatic rings; and more preferably, one of the $R^1$ is a trifluoromethyl group, and the other $R^1$ are each independently selected from the group consisting of hydrogen, a methyl group, a trifluoromethyl group, and a phenyl group.
In the general formula (B-1), X is each independently selected from the group consisting of -O-, $-C(R^3)_2-$, and $-SO_2-$.
In the general formula (B-1), $R^3$ is each independently selected from the group consisting of hydrogen, halogens, optionally substituted alkyl groups, optionally substituted aromatic rings, and optionally substituted heterocyclic rings. Two neighboring $R^3$ are optionally bonded to form a cycloalkyl group.
The matters described for the substituent in the $R^1$ in the general formula (A-1) are appropriately applicable to the substituent in the $R^3$ in the general formula (B-1).
More preferably, the $R^3$ is each independently selected from the group consisting of hydrogen, fluorine, and a

methyl group.

The diamine as a compound represented by the general formula (B-1) includes two amino groups ($-NH_2$).

When m is 0, the two amino groups can substitute at any two positions of the benzene ring shown at the left end of the general formula (B-1). When m is 1, 2, or 3, the two amino groups can substitute at any two positions of the condensed benzene ring.

[Chem. 22]

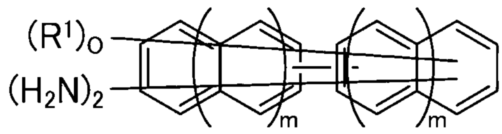

B-2

In the general formula (B-2), $R^1$ is each independently selected from the group consisting of hydrogen, halogens, optionally substituted alkyl groups, optionally substituted alkoxy groups, optionally substituted aromatic rings, and optionally substituted heterocyclic rings. At least one $R^1$ includes a fluorine atom.

The matters described for the substituent in the $R^1$ in the general formula (A-1) are appropriately applicable to the substituent in the $R^1$ in the general formula (B-2).

Preferably, one of the $R^1$ is fluorine, and the other $R^1$ are each independently selected from the group consisting of hydrogen, fluorine, and alkyl groups having 1 to 4 carbon atoms; and more preferably, one of the $R^1$ is fluorine, and the other $R^1$ are each independently selected from the group consisting of hydrogen, fluorine, and a methyl group.

In the general formula (B-2), m each independently represents an integer of 0 to 2, preferably 0 or 1, and more preferably 0.

o represents an integer of 0 to the maximum substituent number, preferably an integer corresponding to 25% or more of the maximum substituent number, and more preferably an integer corresponding to 50% or more of the maximum substituent number.

The diamine as a compound represented by the general formula (B-2) includes two amino groups ($-NH_2$).

When m is 0, the two amino groups can substitute at any two positions of the benzene rings shown at both ends of the general formula (B-2), and may substitute at the same benzene ring or may separately substitute at the two benzene rings. When m is 1 or 2, the two amino groups can substitute at any two positions of two condensed benzene rings, and may substitute at the same condensed benzene ring or may separately substitute at the two condensed benzene rings.

In one embodiment, the general formula (B-1) is preferably general formula (B-1a) below or general formula (B-1b) below, and the general formula (B-2) is preferably general formula (B-2a) below.

The general formula (B-1a) is one of the forms in which m=0 and n=0 in the general formula (B-1).

The general formula (B-1b) is one of the forms in which n=0 in the general formula (B-1).

The general formula (B-2a) is one of the forms in which m=0 in the general formula (B-2).

[Chem. 23]

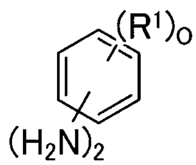

B-1a

In the general formula (B-1a), $R^1$ is each independently selected from the group consisting of hydrogen, halogens, optionally substituted alkyl groups, optionally substituted alkoxy groups, optionally substituted aromatic rings, and optionally substituted heterocyclic rings.

The $R^1$ is preferably each independently selected from the group consisting of fluorine and alkyl groups having 1 to 4 carbon atoms, and is more preferably each independently selected from the group consisting of fluorine and a methyl group.

In the general formula (B-1a), o represents an integer of 0 to 4, preferably an integer of 1 to 4, and more preferably an integer of 2 to 4.

[Chem. 24]

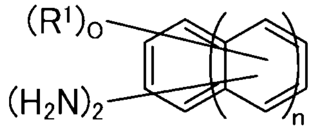

B-1b

In the general formula (B-1b), $R^1$ is each independently selected from the group consisting of hydrogen, halogens, optionally substituted alkyl groups, optionally substituted alkoxy groups, optionally substituted aromatic rings, and optionally substituted heterocyclic rings.

The $R^1$ is preferably each independently selected from the group consisting of hydrogen, fluorine, and alkyl groups having 1 to 4 carbon atoms, and is more preferably each independently selected from the group consisting of hydrogen, fluorine, and a methyl group.

In the general formula (B-1b), m represents an integer of 1 to 3, preferably 1 or 2, and more preferably 1.

o represents an integer of 0 to the maximum substituent number, preferably an integer corresponding to 25% or more of the maximum substituent number, and more preferably an integer corresponding to 50% or more of the maximum substituent number.

[Chem. 25]

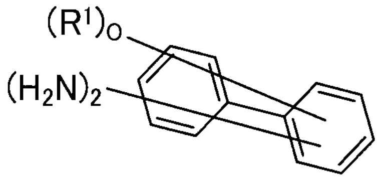

B-2a

In the general formula (B-2a), $R^1$ is each independently selected from the group consisting of hydrogen, halogens, optionally substituted alkyl groups, optionally substituted alkoxy groups, optionally substituted aromatic rings, and optionally substituted heterocyclic rings. At least one $R^1$ includes a fluorine atom.

Preferably, one of the $R^1$ is fluorine, and the other $R^1$ are each independently selected from the group consisting of hydrogen, fluorine, and alkyl groups having 1 to 4 carbon atoms; and more preferably, one of the $R^1$ is fluorine, and the other $R^1$ are each independently selected from the group consisting of hydrogen, fluorine, and a methyl group.

In the general formula (B-2a), o represents an integer of 0 to 8, preferably an integer of 2 to 8, and more preferably an integer of 4 to 8.

[Second Embodiment]

The polyimide resin for the substrate material in the second embodiment of the present disclosure is a polyimide resin including an acid anhydride and a diamine. The acid anhydride is one or more selected from the group consisting of compounds represented by general formula (A-2a) to general formula (A-2g) below, and the diamine is one or more selected from the group consisting of compounds represented by general formula (B-3) below and compounds represented by general formula (B-4) below.

<Acid Anhydride>

The acid anhydride is one or more selected from the group consisting of compounds represented by general formula (A-2a) to general formula (A-2g) below.

The acid anhydrides may be used alone or in combination.

[Chem. 26]

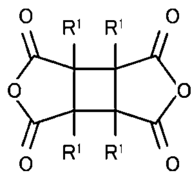
A-2a

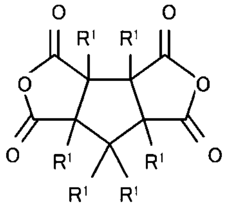
A-2b

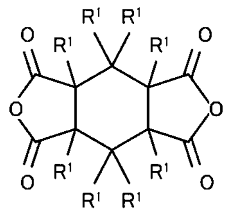
A-2c

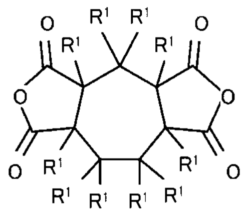
A-2d

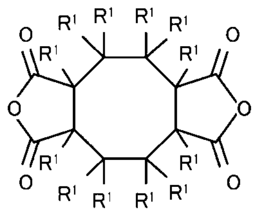
A-2e

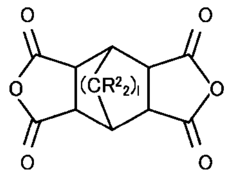
A-2f

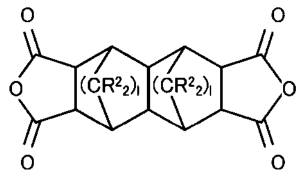
A-2g

In the general formula (A-2a) to the general formula (A-2g), $R^1$ is each independently selected from the group consisting of hydrogen, halogens, optionally substituted alkyl groups, optionally substituted alkoxy groups, optionally substituted aromatic rings, and optionally substituted heterocyclic rings.

The matters described for the substituent in the $R^1$ in the general formula (A-1) are appropriately applicable to the substituent in the $R^1$ in the general formula (A-2a) to the general formula (A-2g).

The $R^1$ is preferably each independently selected from the group consisting of hydrogen, fluorine, alkyl groups having 1 to 4 carbon atoms, and fluoroalkyl groups having 1 to 4 carbon atoms, and is more preferably each independently selected from the group consisting of hydrogen, fluorine, a methyl group, and a trifluoromethyl group.

In the general formula (A-2a) to the general formula (A-2g), l represents an integer of 1 to 3, and preferably 1 or 2.

In the general formula (A-2a) to the general formula (A-2g), $R^2$ is each independently selected from the group consisting of hydrogen, halogens, optionally substituted alkyl groups, optionally substituted alkoxy groups, optionally substituted aromatic rings, and optionally substituted heterocyclic rings.

The matters described for the substituent in the $R^1$ in the general formula (A-1) are appropriately applicable to the substituent in the $R^2$ in the general formula (A-2a) to the general formula (A-2g).

The $R^2$ is preferably each independently selected from the group consisting of hydrogen, fluorine, alkyl groups having 1 to 4 carbon atoms, and fluoroalkyl groups having 1 to 4 carbon atoms, and is more preferably each independently selected from the group consisting of hydrogen, fluorine, a methyl group, and a trifluoromethyl group.

<Diamine>

The diamine is one or more selected from the group consisting of compounds represented by general formula (B-3) below and compounds represented by general formula (B-4) below.

In one embodiment, the general formula (B-3) is preferably general formula (B-3a) below or general formula (B-3b) below, and the general formula (B-4) is preferably general formula (B-4a) below.

The diamines may be used alone or in combination.

[Chem. 27]

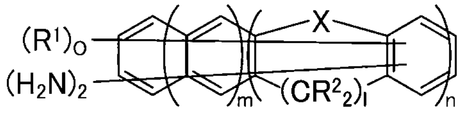

B-3

In the general formula (B-3), $R^1$ is each independently selected from the group consisting of hydrogen, halogens, optionally substituted alkyl groups, optionally substituted alkoxy groups, optionally substituted aromatic rings, and optionally substituted heterocyclic rings.

The matters described for the substituent in the $R^1$ in the general formula (A-1) are appropriately applicable to the substituent in the $R^1$ in the general formula (B-3).

The $R^1$ is preferably each independently selected from the group consisting of hydrogen, fluorine, and alkyl groups having 1 to 4 carbon atoms, and is more preferably each independently selected from the group consisting of hydrogen, fluorine, and a methyl group.

In the general formula (B-3), l represents an integer of 1 to 3, preferably 1 or 2, and more preferably 1.

m represents an integer of 0 to 3, preferably 0, 1, or 2, and more preferably 0 or 1.

n represents an integer of 0 to 5, preferably an integer of 0 to 3, and more preferably 0 or 1.

o represents an integer of 0 to the maximum substituent number, preferably an integer corresponding to 25% or more of the maximum substituent number, and more preferably an integer corresponding to 50% or more of the maximum substituent number.

In the general formula (B-3), $R^2$ is each independently selected from the group consisting of hydrogen, halogens, optionally substituted alkyl groups, optionally substituted aromatic rings, and optionally substituted heterocyclic rings. At least one $R^2$ is an optionally substituted fluoroalkyl group.

The matters described for the substituent in the $R^1$ in the general formula (A-1) are appropriately applicable to the substituent in the $R^2$ in the general formula (B-3).

Preferably, one of the $R^2$ is a fluoroalkyl group having 1 to 4 carbon atoms, and the other $R^2$ are each independently selected from the group consisting of hydrogen, fluorine, alkyl groups having 1 to 4 carbon atoms, and aromatic rings; and more preferably, one of the $R^1$ is a trifluoromethyl group, and the other $R^1$ are each independently selected from the group consisting of hydrogen, a methyl group, a trifluoromethyl group, and a phenyl group.

In the general formula (B-3), X is each independently selected from the group consisting of -O-, $-C(R^3)_2-$, and $-SO_2-$.

In the general formula (B-3), $R^3$ is each independently selected from the group consisting of hydrogen, halogens, optionally substituted alkyl groups, optionally substituted aromatic rings, and optionally substituted heterocyclic rings. Two neighboring $R^3$ are optionally bonded to form a cycloalkyl group.

The matters described for the substituent in the $R^1$ in the general formula (A-1) are appropriately applicable to the substituent in the $R^3$ in the general formula (B-3).

The $R^3$ is each independently selected from the group consisting of hydrogen, fluorine, and a methyl group.

[Chem. 28]

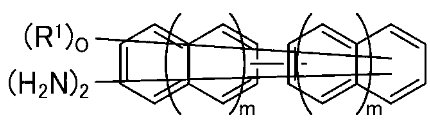

B-4

In the general formula (B-4), $R^1$ is each independently selected from the group consisting of hydrogen, halogens, optionally substituted alkyl groups, optionally substituted alkoxy groups, optionally substituted aromatic rings, and optionally substituted heterocyclic rings.

The matters described for the substituent in the $R^1$ in the general formula (A-1) are appropriately applicable to the substituent in the $R^1$ in the general formula (B-4).

The $R^1$ is preferably each independently selected from the group consisting of hydrogen, fluorine, and alkyl groups having 1 to 4 carbon atoms, and is more preferably each independently selected from the group consisting of

hydrogen, fluorine, and a methyl group.

In the general formula (B-4), m each independently represents an integer of 0 to 2, preferably 0 or 1, and more preferably 0.

o represents an integer of 0 to the maximum substituent number, preferably an integer corresponding to 25% or more of the maximum substituent number, and more preferably an integer corresponding to 50% or more of the maximum substituent number.

In one embodiment, the general formula (B-3) is preferably general formula (B-3a) below or general formula (B-3b) below, and the general formula (B-4) is preferably general formula (B-4a) below.

The general formula (B-3a) is one of the forms in which m=0 and n=0 in the general formula (B-3).

The general formula (B-3b) is one of the forms in which n=0 in the general formula (B-3).

The general formula (B-4a) is one of the forms in which m=0 in the general formula (B-4).

[Chem. 29]

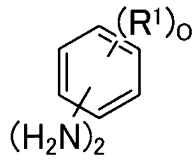

B-3a

In the general formula (B-3a), $R^1$ is each independently selected from the group consisting of hydrogen, halogens, optionally substituted alkyl groups, optionally substituted alkoxy groups, optionally substituted aromatic rings, and optionally substituted heterocyclic rings.

The $R^1$ is preferably each independently selected from the group consisting of fluorine and alkyl groups having 1 to 4 carbon atoms, and is more preferably each independently selected from the group consisting of fluorine and a methyl group.

In the general formula (B-3a), o represents an integer of 0 to 4, preferably an integer of 1 to 4, and more preferably an integer of 2 to 4.

[Chem. 30]

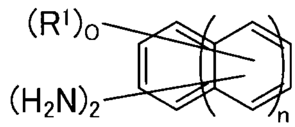

B-3b

In the general formula (B-3b), $R^1$ is each independently selected from the group consisting of hydrogen, halogens, optionally substituted alkyl groups, optionally substituted alkoxy groups, optionally substituted aromatic rings, and optionally substituted heterocyclic rings.

The $R^1$ is preferably each independently selected from the group consisting of hydrogen, fluorine, and alkyl groups having 1 to 4 carbon atoms, and is more preferably each independently selected from the group consisting of hydrogen, fluorine, and a methyl group.

In the general formula (B-3b), m represents an integer of 1 to 3, preferably 1 or 2, and more preferably 1.

o represents an integer of 0 to the maximum substituent number, preferably an integer corresponding to 25% or more of the maximum substituent number, and more preferably an integer corresponding to 50% or more of the maximum substituent number.

[Chem. 31]

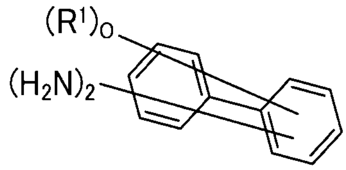

B-4a

In the general formula (B-4a), $R^1$ is each independently selected from the group consisting of hydrogen, halogens, optionally substituted alkyl groups, optionally substituted alkoxy groups, optionally substituted aromatic rings, and optionally substituted heterocyclic rings. At least one $R^1$ includes a fluorine atom.
Preferably, one of the $R^1$ is fluorine, and the other $R^1$ are each independently selected from the group consisting of hydrogen, fluorine, and alkyl groups having 1 to 4 carbon atoms; and more preferably, one of the $R^1$ is fluorine, and the other $R^1$ are each independently selected from the group consisting of hydrogen, fluorine, and a methyl group.
In the general formula (B-4a), o represents an integer of 0 to 8, preferably an integer of 2 to 8, and more preferably an integer of 4 to 8.

[Third Embodiment]

The polyimide resin for the substrate material in the third embodiment of the present disclosure is a polyimide resin including a structural unit of general formula (1) below.

[Chem. 32]

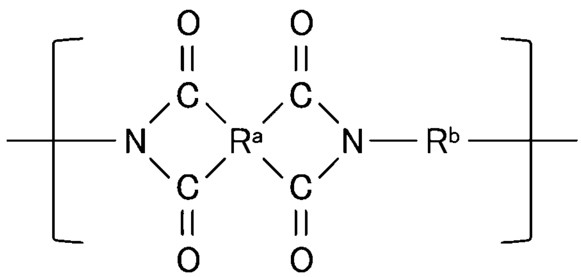

General Formula (1)

In the general formula (1), the $R^a(CO)_4$ moiety represents a tetravalent group derived from a tetravalent tetracarboxylic acid having 2 or more carbon atoms, and the $R^b(N)_2$ moiety represents a tetravalent group derived from a divalent diamine having 2 or more carbon atoms.
The free volume fraction and the average neighboring atom number of the polyimide resin in an amorphous state that are calculated through molecular dynamics calculation in an equilibrium state in which a temperature is 300 K and a pressure is 1 atm, satisfy condition (1) below:

(1) the free volume fraction is 0.23 to 0.32 and the average neighboring atom number is 3.90 to 4.60, and no trifluoromethyl group is included.

The average neighboring atom number is an average of the number of neighboring atoms per the number of atoms constituting a system of the molecular dynamics calculation.
The number of neighboring atoms is the total number of atom pairs satisfying (a) and (b) below:

(a) the atom pairs each have one shared side of Voronoi cells in which the atoms are sites, and
(b) the atom pairs are each a pair of atoms 4 bonds or more away from each other, or a pair of atoms existing in different molecules.

-Free Volume Fraction-

The "free volume" is a quantity calculated according to: a volume per unit mass of a molecule at a constant temperature and pressure, i.e., a specific volume v, minus an occupied volume $v_0$ of the molecule. The "free volume" can be represented as a free volume vf according to formula 1 below.

The "free volume fraction" is the free volume vf per the specific volume v, and can be represented as a free volume fraction f according to formula 2 below.

(Formula 1)

$$vf=v-v_0$$

(Formula 2)

$$f=(v-v_0)/v$$

The free volume fraction in the present embodiment is the free volume fraction of the polyimide resin in an amorphous state calculated through molecular dynamics calculation in an equilibrium state in which a temperature is 300 K and a pressure is 1 atm, and can be obtained according to formula 3 below.

Specifically, the free volume fraction can be calculated through Python library molecular dynamics calculation using an automatic polymer property calculation system, RadonPy (open source software), and the free volume fraction f can be calculated according to the formula 3 below based on coordinates of each atom in the equilibrium state in molecular dynamics simulation described below.

For the van der Waals radius of each atom in the formula 3 below, a value calculated based on a GAFF2 force field (Reference 1 below) was used.

Reference 1:

X. He, V. H. Man, W. Yang, T.-S. Lee, and J. Wang, A Fast and High-Quality Charge Model for the next Generation General AMBER Force Field, J. Chem. Phys. 153, 114502 (2020).
(Formula 3)

[Math. 1]

$$f = (v - v_o)/v$$
$$v_o = 1.3v_{vdw}$$
$$v_{vdw} = \sum_i \left( \frac{4}{3}\pi r_i^3 - \sum_j \frac{1}{3}\pi h_{ij}^2 (3r_i - h_{ij}) \right)$$
$$h_{ij} = \frac{r_j^2 - (r_i - d_{ij})^2}{2d_{ij}}$$

f: Free volume fraction of amorphous system
v: Volume of amorphous system
$v_o$: Occupied volume of polymer in amorphous system
$v_{vdw}$: van der Waals volume of polymer in amorphous system
$r_i$: van der Waals radius of atom i
$r_j$: van der Waals radius of atom j bonded to atom i
$d_{ij}$: Distance between atom i and atom j

-Average Neighboring Atom Number-

The average neighboring atom number is an average of the number of neighboring atoms per the number of atoms constituting a system of the molecular dynamics calculation.

The number of neighboring atoms is the total number of atom pairs satisfying (a) and (b) below:

(a) the atom pairs each have one shared side of Voronoi cells in which the atoms are sites, and
(b) the atom pairs are each a pair of atoms 4 bonds or more away from each other, or a pair of atoms existing in different molecules.

Specifically, the number of neighboring atoms is calculated through molecular dynamics calculation as the total number of atom pairs satisfying (a) and (b) below:

(a) in a Voronoi diagram calculated with each atom serving as a site, the atom pairs each have a shared Voronoi side (a pair of sites), and
(b) the atom pairs are each a pair of atoms 4 bonds or more away from each other, or a pair of atoms existing in different molecules.

The average neighboring atom number can be calculated by dividing the total number of pairs satisfying (a) and (b) above (i.e., the number of neighboring atoms) in a system having a periodic boundary condition, by the number of atoms constituting the system.

The average neighboring atom number in the present embodiment is the average neighboring atom number of the polyimide resin in an amorphous state calculated through molecular dynamics calculation in an equilibrium state in which a temperature is 300 K and a pressure is 1 atm, and can be calculated in the following manner. Specifically, based on coordinates of each atom in the equilibrium state in the molecular dynamics simulation described below, Voronoi polyhedral analysis is performed with each atom serving as a site. The total number of atom pairs satisfying (a) and (b) above in an amorphous cell is divided by the total number of atoms constituting the amorphous cell, thereby calculating the average neighboring atom number per atom.

The free volume fraction and the average neighboring atom number satisfy the condition (1) below, and preferably satisfy condition (2) or (3) below.

According to the molecular dynamics simulation described below, when the condition (1) or (2) below is satisfied, it is possible to achieve both a low dielectric constant that is 2.5 or less at 10 GHz, and a low linear expansion coefficient that is 40 ppm/K or less:

(1) the free volume fraction is 0.23 to 0.32, the average neighboring atom number is 3.90 to 4.60, and no trifluoromethyl group is included.
(2) The free volume fraction is 0.24 to 0.32, the average neighboring atom number is 3.90 to 4.50, and no trifluoromethyl group is included.

When the condition (2) is satisfied, it is possible to achieve both a low dielectric constant that is 2.5 or less at 10 GHz, and a low linear expansion coefficient that is 30 ppm/K or less.
(3) The free volume fraction is 0.28 to 0.32, the average neighboring atom number is 3.90 to 4.50, and no trifluoromethyl group is included.

When the condition (3) is satisfied, it is possible to achieve both a low dielectric constant that is 2.5 or less at 10 GHz, and a low linear expansion coefficient that is 20 ppm/K or less.

[Fourth Embodiment]

The polyimide resin for the substrate material in the fourth embodiment of the present disclosure is a polyimide resin for a substrate material identical to the polyimide resin for the substrate material in the first embodiment or the polyimide resin for the substrate material in the second embodiment, except that the free volume fraction and the average neighboring atom number of the polyimide resin in an amorphous state that are calculated through molecular dynamics calculation in an equilibrium state in which a temperature is 300 K and a pressure is 1 atm, satisfy condition (1) below:

(1) the free volume fraction is 0.23 to 0.32 and the average neighboring atom number is 3.90 to 4.60, and no trifluoromethyl group is included.

The average neighboring atom number is an average of the number of neighboring atoms per the number of atoms constituting a system of the molecular dynamics calculation.

The number of neighboring atoms is the total number of atom pairs satisfying (a) and (b) below:

(a) the atom pairs each have one shared side of Voronoi cells in which the atoms are sites, and
(b) the atom pairs are each a pair of atoms 4 bonds or more away from each other, or a pair of atoms existing in different molecules.

The matters described in the first embodiment and the second embodiment are appropriately applicable to the polyimide resin for the substrate material in the first embodiment and the polyimide resin for the substrate material in the second embodiment.

The matters described in the third embodiment are appropriately applicable to the conditions for the free volume fraction and the average neighboring atom number.

The free volume fraction and the average neighboring atom number satisfy the condition (1) above, and preferably satisfy the condition (2) or (3) above.

[Properties]

The polyimide resins for the substrate materials in the first embodiment to the fourth embodiment preferably have a dielectric constant at 10 GHz of 2.5 or less and a linear expansion coefficient of 40 ppm/K or less.

-Dielectric Constant-

The dielectric constant at 10 GHz of the polyimide resin is preferably 2.5 or less, and more preferably 2.4 or less.

Specifically, the dielectric constant at 10 GHz of the polyimide resin can be measured in the following manner. Specifically, a polyimide film obtained by a below-described production method of a polyimide film is measured through SPDR (resonator method) using a vector network analyzer (E5063A, available from Keysight). The polyimide film used as a measurement sample is used after being left to stand at a temperature of 23±1°C and a humidity of 50±5%RH for 24 hours or longer.

A specific method for obtaining a calculated value of the dielectric constant at 10 GHz of the polyimide resin through molecular dynamics simulation is, for example, the following procedure as described in the molecular dynamics simulation described below.

Through molecular dynamics calculation, the length of a dielectric relaxation function (e.g., 100 ns) and the time length for calculating a dipole moment (e.g., 500 ns) are set, and the dipole moment of a target substance is calculated. Thus, time-series data of the dipole moment is generated.

Next, based on received calculation conditions, a high-pass filter is designed. The cutoff frequency of the high-pass filter is a reciprocal of the length of the dielectric relaxation function. When the length of the dielectric relaxation function is 100 ns, the cutoff frequency is 10 MHz.

Next, the designed high-pass filter is used to remove low-frequency components from the time-series data of the dipole moment. In other words, the frequency band equal to or higher than the cutoff frequency is extracted from the time-series data of the dipole moment. This generates time-series data of the dipole moment after filtering, in which the low-frequency components (e.g., less than 10 GHz) are removed.

Next, the time-series data of the dipole moment after filtering is used as M(t), and a dielectric relaxation function $\Phi(t)$ is calculated according to formula (1). Fitting of the calculated dielectric relaxation function $\Phi(t)$ in formula (2) is performed. Further, the dielectric relaxation function $\Phi_{fit}(t)$ after fitting is frequency-resolved by a Fourier transform of formula (3). Thus, a frequency-dependent complex dielectric constant is obtained. The dielectric constant at a frequency of 10 GHz can be determined by the real part of the complex dielectric constant at a frequency of 10 GHz.

By removing the low-frequency components (e.g., less than 10 GHz), which are susceptible to local effects in the simulation, from the time-series data of the dipole moment, the dielectric relaxation function of the polyimide resin serving as the target substance can be accurately derived.

[Math. 2]

$$\Phi(t) = \frac{\langle \mathrm{M}(t) \cdot \mathrm{M}(0) \rangle - \langle \mathrm{M} \rangle^2}{\langle \mathrm{M}(0)^2 \rangle - \langle \mathrm{M} \rangle^2} \quad \cdots (1)$$

[Math. 3]

$$\Phi_{fit}(t) = A\exp\left[-\left(\frac{t}{10^{\alpha_1}}\right)^{\beta_1}\right] + (1 - A)\exp\left[-\left(\frac{t}{10^{\alpha_2}}\right)^{\beta_2}\right] \quad \cdots (2)$$

[Math. 4]

$$\frac{\varepsilon^*(i\omega)-\varepsilon_\infty}{\Delta\varepsilon}=\int_0^\infty dt\left[-\frac{d\Phi_{fit}(t)}{dt}\right]\exp(-i\omega t) \quad \ldots (3)$$

-Linear Expansion Coefficient-

The linear expansion coefficient means a ratio of a deformation ΔL per a temperature change of 1 K (Kelvin) or 1°C, relative to the original length L.

The linear expansion coefficient of the polyimide resin is preferably 40 ppm/K or less, more preferably 30 ppm/K or less, and further preferably 20 ppm/K or less.

Specifically, the linear expansion coefficient of the polyimide resin can be measured using a thermomechanical analyzer (EXSTAR6000TMA/SS6000, available from SII Nanotechnology) under the following measurement conditions for a polyimide film obtained by the below-described production method of the polyimide film.

--Measurement Conditions--

First step: Increasing the temperature to 150°C at a temperature increase rate of 5°C/min to remove adsorbed water from a sample.

Second step: Cooling the sample in air to room temperature at a temperature decrease rate of 5°C/min.

Third step: Performing nonpreparatory measurement of the sample at a temperature increase rate of 5°C/min.

The average value of the linear expansion coefficients in a temperature range of 50°C to 200°C in the nonpreparatory measurement is determined as an intended linear expansion coefficient of the polyimide film.

A specific method for obtaining a calculated value of the linear expansion coefficient of the polyimide resin through molecular dynamics simulation is, for example, the following procedure as described in the molecular dynamics simulation described below.

First, based on a volume V and a fluctuation in an enthalpy H in equilibrium calculation, a volume expansion rate $\alpha_P$ is calculated according to a formula below [see Reference 2 below]. $k_B$ represents the Boltzmann constant, and T represents a temperature.

Reference 2:

M. P. Allen and D. J. Tildesley, Computer Simulation of Liquids (Clarendon Press, New York, 1989).

[Math. 5]

$$\alpha_P=\frac{\langle\delta V\delta H\rangle}{k_B T^2\langle V\rangle}$$

Next, assuming the isotropy of a system, a linear expansion coefficient $\alpha_L$ is derived according to a formula below.

[Math. 6]

$$\alpha_L=\frac{1}{3}\alpha_P$$

-Dielectric Tangent-

The dielectric tangent of the polyimide resin is preferably 0.0040 or less, more preferably 0.0035 or less, and further preferably 0.0030 or less.

A dielectric loss is proportional to the product of the square root of the dielectric constant and the dielectric tangent. Thus, when the dielectric tangent is 0.0040 or less, the dielectric loss can be effectively reduced.

Specifically, the dielectric tangent of the polyimide resin can be measured in the following manner. Specifically, a polyimide film obtained by the below-described production method of the polyimide film is measured through SPDR

(resonator method) at a frequency of 1 GHz or 10 GHz using a vector network analyzer (E5063A, available from Keysight). The polyimide film used as a measurement sample is used after being left to stand at a temperature of 23±1°C and a humidity of 50±5%RH for 24 hours or longer.

-Glass Transition Temperature-

The glass transition temperature of the polyimide resin is preferably 260°C or more, more preferably 280°C or more, and further preferably 300°C or more.

When the glass transition temperature is 260°C or more, the polyimide film can be a material for substrates having favorable solder temperature resistance and dimensional stability.

-Haze-

The haze of the polyimide resin is preferably 20% or less, more preferably 10% or less, and further preferably 5% or less.

When the haze is 20% or less, visibility of alignment marks can be obtained in a photolithography processing step in a state of a laminate and a subsequent mounting step of a substrate. Thus, the polyimide resin is suitably used.

Specifically, the haze of the polyimide resin can be measured using a spectroscopic haze meter (HSP-150Vis, available from MURAKAMI COLOR RESEARCH LABORATORY CO., LTD.) for a polyimide film obtained by the below-described production method of the polyimide film. The average thickness of the polyimide film serving as a measurement sample is preferably 5 μm or more and 80 μm or less.

-Elongation at Break-

The elongation at break of the polyimide resin is preferably 20% or more, more preferably 25% or more, and further preferably 30% or more.

When the elongation at break is 20% or more, breakage during film conveyance is less likely to occur in a polyimide film production step, and thus efficient productivity is maintained. Further, bending resistance in a state of a flexible printed circuit is maintained, and thus cracking and disconnection of interconnects in the mounting step are less likely to occur.

-Tensile Modulus-

The tensile modulus of the polyimide resin is preferably 5 GPa or more, more preferably 6 GPa or more, and further preferably 7 GPa or more.

When the tensile modulus is 5 GPa or more, film elongation under tension applied during film conveyance in a polyimide film production step is suppressed, and dimensional stability is maintained.

The elongation at break and the tensile modulus of the polyimide resin can be measured in the following manner. Specifically, a polyimide film produced by the below-described production method of the polyimide film is cut into a strip having a width of 10 mm and a length of 80 mm, thereby preparing a measurement sample. The prepared measurement sample is measured for the elongation at break and the tensile modulus using a TENSILON universal testing machine (RTM-100, available from ORIENTEC CO., LTD.) in accordance with the Japanese Industrial Standards (JIS K 7127:1999).

The width of the measurement sample is set to 10 mm, the chuck interval is set to 50 mm, the testing speed is set to 50 mm/min, and the number of measurement samples is set to n=10, in which the average value is calculated.

[Synthesis Method of Polyimide Resin]

No particular limitation is imposed on a synthesis method of the polyimide resin, and the synthesis method of the polyimide resin can be appropriately selected from publicly known methods in accordance with the intended purpose. For example, equimolar amounts of an acid anhydride and a diamine are polymerized to synthesize a polyamic acid (polyamide acid), which is a precursor of a polyimide. The obtained polyamic acid is heated at a temperature of 200°C or higher, or is allowed to undergo an imidization (dehydration and cyclization) reaction by use of a catalyst, thereby enabling formation of the polyimide.

Instead of or in combination with the acid anhydride, a tetracarboxylic acid corresponding to the acid anhydride may be used.

When a plurality of acid anhydrides and/or a plurality of diamines are used, the resulting polyamic acid and the resulting polyimide resin may be a random copolymer, a block copolymer, or a mixture of the random copolymer and the

block copolymer.

The polyamic acid, and a composition including the polyamic acid can be synthesized, for example, in accordance with the following procedure.

A thermometer, and a stirring rod equipped with a stirring blade are set to a 300 mL four-necked separable flask. Next, a solvent (e.g., dimethylacetamide, DMAC, or the like) is charged into the flask in a dry nitrogen stream, and is then heated to 60°C. After heating, a diamine is charged and dissolved while the solvent is being stirred. Next, an equimolar amount of an acid anhydride is charged, followed by stirring to perform polymerization between the acid anhydride and the diamine. Subsequently, the reaction mixture is cooled to room temperature, if necessary, followed by addition of the solvent and filtration through a filter, thereby enabling formation of the composition including the polyamic acid.

The reaction temperature at which the acid anhydride and the diamine are polymerized is preferably -20°C to 150°C, and more preferably 0°C to 100°C. The reaction time is preferably 0.1 hours to 24 hours, and more preferably 0.5 hours to 12 hours. Also, the amount by mole of the acid anhydride used in the reaction is preferably equal to the amount by mole of the diamine used in the reaction. The closer the polyamide acid is to having equal amounts of acid anhydride and diamine, the more readily a polyimide film having high mechanical properties can be obtained.

A method of synthesizing the polyimide from the polyamic acid through the imidization reaction is, for example, the following procedure.

The obtained composition including the polyamic acid is coated onto a substrate (e.g., through spin coating or the like). Next, the coated product is dried (e.g., at 80°C for 5 minutes) using a hot plate. Subsequently, the dried product is heated at a temperature of 200°C or higher, thereby enabling formation of a film-like polyimide resin on the substrate.

A method of performing heating at a temperature of 200°C or higher is, for example, a method including increasing the temperature from 50°C at 4°C/minute in a nitrogen atmosphere (oxygen concentration: 20 ppm or less) using an oven, performing heating at 180°C for 30 minutes, and subsequently performing heating at 350°C for 30 minutes.

[Identification Method of Polyimide Resin]

No particular limitation is imposed on the identification method of the polyimide resin, and the identification method of the polyimide resin can be appropriately selected in accordance with the intended purpose. For example, the identification method of the polyimide resin is, for example, a method of analyzing and identifying the components, such as the acid anhydride, the diamine, and the like, through infrared attenuated total reflection spectroscopy (IR-ATR) using a Fourier transform infrared spectrometer (FT-IR). The measurement by the FT-IR can be performed using, for example, Nicolet 6700 (available from Thermo Fisher Scientific).

(Polyamic Acid for Substrate Material)

The polyamic acid for the substrate material of the present disclosure is a precursor of the polyimide resin for the substrate of the present disclosure that has both a low dielectric constant and a low linear expansion coefficient. The polyamic acid of the present disclosure is a polyamic acid (1) being a precursor of the polyimide resin for the substrate material in the first embodiment, or (2) being a precursor of the polyimide resin for the substrate material in the second embodiment.

[First Embodiment]

The polyamic acid for the substrate material in the first embodiment of the present disclosure is a precursor of the polyimide resin for the substrate material in the first embodiment. The polyamic acid in the first embodiment is a polyamic acid including an acid anhydride and a diamine. The acid anhydride is one or more selected from the group consisting of the compounds represented by the general formula (A-1). The diamine is one or more selected from the group consisting of the compounds represented by the general formula (B-1) and the compounds represented by the general formula (B-2).

The matters described for the polyimide resin for the substrate material in the first embodiment are appropriately applicable to the acid anhydride and the diamine.

[Second Embodiment]

The polyamic acid for the substrate material in the second embodiment of the present disclosure is a precursor of the polyimide resin for the substrate material in the second embodiment. The polyamic acid in the second embodiment is a polyamic acid including an acid anhydride and a diamine. The acid anhydride is one or more selected from the group consisting of compounds represented by general formula (A-2a) to general formula (A-2g) below. The diamine is one or more selected from the group consisting of compounds represented by general formula (B-3) below and compounds represented by general formula (B-4) below.

The matters described for the polyimide resin for the substrate material in the second embodiment are appropriately applicable to the acid anhydride and the diamine.

(Composition for Substrate Material)

[First Embodiment]

The composition for the substrate material in the first embodiment of the present disclosure includes a polyimide resin, and if necessary, may further include other components, such as a solvent and the like.

The polyimide resin is suitably the polyimide resin for the substrate material in the first embodiment, the polyimide resin for the substrate material in the second embodiment, the polyimide resin for the substrate material in the third embodiment, the polyimide resin for the substrate material in the fourth embodiment, or the like. These may be used alone or in combination.

The composition for the substrate material in the first embodiment can be successfully prepared through an imidization reaction of the composition for the substrate material in the second embodiment.

[Second Embodiment]

The composition for the substrate material in the second embodiment of the present disclosure includes a polyamic acid and a solvent, and if necessary, may further include other components.

The polyamic acid is suitably the polyamic acid for the substrate material in the first embodiment, the polyamic acid for the substrate material in the second embodiment, or the like. These may be used alone or in combination.

<Solvent>

No particular limitation is imposed on the solvent, and the solvent can be appropriately selected in accordance with the intended purpose. Examples of the solvent include water, N-methyl-2-pyrrolidone, N,N-dimethylformamide, N,N-dimethylacetamide, N,N-dimethylisobutylamide, 3-methoxy-N,N-dimethylpropionamide, 3-butoxy-N,N-dimethylpropionamide, γ-butyrolactone, ethyl lactate, 1,3-dimethyl-2-imidazolidinone, N,N'-dimethylpropyleneurea, 1,1,3,3-tetramethylurea, dimethylsulfoxide, sulfolane, propylene glycol monomethyl ether, propylene glycol monomethyl ether acetate, diethylene glycol ethyl methyl ether, diethylene glycol dimethyl ether, and the like.

These may be used alone or in combination.

No particular limitation is imposed on the amount of the solvent, and the amount of the solvent can be appropriately selected in accordance with the intended purpose. The amount of the solvent is preferably 150 parts by mass or more, and more preferably 200 parts by mass or more, relative to 100 parts by mass of the polyimide resin and/or the polyamic acid in the composition. The amount of the solvent is preferably 2,000 parts by mass or less, and more preferably 1,000 parts by mass or less.

When the amount of the solvent is 150 parts by mass or more and 2,000 parts by mass or less, the viscosity of the resulting composition becomes suitable for coating, and the thicknesses of the coated composition and the resulting polyimide film can be readily adjusted.

<Other Components>

Examples of the other components include a catalyst that catalyzes imidization, a dehydrating agent, and the like.

-Catalyst-

Examples of the catalyst include amines and the like.

Examples of the amines include, for example, aliphatic tertiary amines, such as trimethylamine, triethylenediamine, and the like; aromatic tertiary amines, such as dimethylaniline and the like; and heterocyclic tertiary amines, such as isoquinoline, pyridine, β-picoline, and the like.

These amines may be used alone or in combination. Of these, heterocyclic tertiary amines are preferable, and β-picoline is more preferable.

-Dehydrating Agent-

Examples of the dehydrating agent include, for example, aliphatic carboxylic anhydrides, such as acetic anhydride, propionic anhydride, butyric anhydride, and the like; and aromatic carboxylic anhydrides, such as benzoic

anhydride and the like.

These dehydrating agents may be used alone or in combination. Of these, acetic anhydride and benzoic anhydride are preferable, and acetic anhydride is more preferable.

No particular limitation is imposed on the respective amounts of the catalyst and the dehydrating agent, and the respective amounts of the catalyst and the dehydrating agent can be appropriately selected in accordance with the intended purpose. The respective amounts of the catalyst and the dehydrating agent are preferably 0.05 moles to 10 moles, more preferably 0.1 moles to 5 moles, and further preferably 0.5 moles to 3 moles per 1 mole of the amic acid unit of the polyamic acid.

Also, the composition for the substrate material in the first embodiment may include other components, such as inorganic particles, thermal crosslinking agents, thermal acid generators, leveling agents, viscosity adjusters, antioxidants, inorganic pigments, organic pigments, dyes, and the like.

-Inorganic Particles-

The composition for the substrate material in the first embodiment, and a polyimide film described below can include inorganic particles for improving heat resistance of the polyimide film or reducing the linear expansion coefficient.

Examples of the inorganic particles include, for example, inorganic particles of metals, such as platinum, gold, palladium, silver, copper, nickel, zinc, aluminum, iron, cobalt, rhodium, ruthenium, tin, lead, bismuth, tungsten, and the like; and inorganic particles of metal oxides, such as silicon oxide (silica), titanium oxide, aluminum oxide, zinc oxide, tin oxide, tungsten oxide, zirconium oxide, calcium carbonate, barium sulfate, and the like. No particular limitation is imposed on the shape and amount of the inorganic particles, and the shape and amount of the inorganic particles can be appropriately selected in accordance with the intended purpose. Also, the inorganic particles are preferably dispersed uniformly in the composition and the polyimide film, and publicly known methods can be used.

(Polyimide Film for Substrate Material)

The polyimide film for the substrate material of the present disclosure includes a polyimide resin, and if necessary, may further include other components.

The polyimide resin is suitably the polyimide resin for the substrate material in the first embodiment, the polyimide resin for the substrate material in the second embodiment, the polyimide resin for the substrate material in the third embodiment, the polyimide resin for the substrate material in the fourth embodiment, or the like. These may be used alone or in combination.

No particular limitation is imposed on the average thickness of the polyimide film, and the average thickness of the polyimide film can be appropriately selected in accordance with the intended purpose. The average thickness of the polyimide film is preferably 3 μm or more, more preferably 5 μm or more, and further preferably 10 μm or more. When the average thickness is 3 μm or more, mechanical properties sufficient for the substrate for the circuit can be obtained. Also, the average thickness of the polyimide film is preferably 200 μm or less, more preferably 100 μm or less, and further preferably 80 μm or less. When the average thickness is 80 μm or less, toughness sufficient for the substrate for the circuit can be obtained.

The polyimide film can be used for applications as a low-dielectric-constant insulating member. Specifically, the polyimide film is suitably used as films used for the substrate for the circuit, such as flexible printed circuits, cover lay films, heat-resistant insulating tape, heat-resistant adhesive tape, high-density magnetic recording bases, capacitors, and the like.

[Production Method of Polyimide Film]

No particular limitation is imposed on the production method of the polyimide film, and the production method of the polyimide film can be appropriately selected in accordance with the intended purpose. Examples of the production method of the polyimide film include, for example, (I) a production method including a step of coating and drying, over a base, a composition including a polyamic acid, and a step of heating and imidizing the obtained coated film; and (II) a production method including a step of casting and imidizing, over a heated base, a composition including a polyamic acid, thereby forming a gel film, a step of peeling the obtained gel film from the base, and a step of thermally treating the peeled gel film.

No particular limitation is imposed on the base, and the base can be appropriately selected in accordance with the intended purpose. Examples of the base include, for example, glass bases; and metal bases, such as a stainless steel drum, an endless stainless steel belt, an aluminum foil, and the like.

The temperature of the base is preferably 30°C to 200°C, more preferably 40°C to 150°C, and further preferably 50°C to 120°C.

The drying temperature of the gel film is preferably 150°C to 500°C, more preferably 180°C to 400°C, and further preferably 200°C to 300°C.

The thermal treatment temperature of the dried polyimide film is preferably 200°C or more, more preferably 300°C or more, and further preferably 350°C or more.

The gel film and the polyimide film may be stretched in the conveying direction or the widthwise direction in each step.

The obtained polyimide film may be further subjected to an annealing treatment or a treatment for easy adhesion (e.g., electrical treatments, such as a corona treatment, a plasma treatment, and the like, or a blast treatment).

(Laminate)

The laminate of the present disclosure includes a metal layer and a layer including a polyimide resin, and if necessary, may further include other layers.

The layer including the polyimide resin is suitably the polyimide film of the present disclosure or the like.

<Metal Layer>

No particular limitation is imposed on the material of the metal layer, and the material of the metal layer can be appropriately selected in accordance with the intended purpose. Examples of the material of the metal layer include, for example, copper or copper alloys, stainless steel or stainless steel alloys, nickel or nickel alloys, and aluminum or aluminum alloys.

Of these, copper or copper alloys are preferable, and copper alloys including copper, and one or more components selected from the group consisting of nickel, zinc, iron, chromium, cobalt, molybdenum, tungsten, vanadium, beryllium, titanium, tin, manganese, aluminum, phosphorus, and silicon are more preferable.

The metal layer is preferably a metal foil formed through rolling or electrolytic plating, and more preferably a copper foil or a copper alloy foil.

The metal layer and the layer including the polyimide resin are laminated, thereby enabling formation of a metal clad laminate. Also, it is possible to use a product in which a rust preventive layer, a heat-resistant layer, a silane coupling agent, or the like is formed over the surface of the metal layer.

No particular limitation is imposed on the thickness of the metal layer, and the thickness of the metal layer may be any thickness as long as the thickness of the metal layer is sufficient for the metal layer to exhibit sufficient functions in accordance with the intended purpose. The surface of the metal layer is preferably smoother in terms of reduction in transmission loss, and Ra is preferably 1.0 μm or less.

As long as the laminate includes the metal layer and the layer including the polyimide resin, no particular limitation is imposed on the form of the laminate. For example, the polyimide film and the metal layer may be directly laminated, or the polyimide film and the metal layer may be laminated via an adhesive layer.

Also, as illustrated in FIG. 1, the laminate may be a laminate 10 (single-side metal-clad laminate) in which a metal layer 3 is laminated over one surface of a polyimide film 1, if necessary, via an adhesive layer 2. Alternatively, as illustrated in FIG. 2, the laminate may be a laminate 20 (both-side metal-clad laminate) in which the metal layer 3 is laminated over both surfaces of the polyimide film 1, if necessary, via the adhesive layer 2.

No particular limitation is imposed on the material of the adhesive layer, and the material of the adhesive layer can be appropriately selected in accordance with the intended purpose. The material of the adhesive layer may be a thermosetting resin, a thermoplastic resin, or the like. From the viewpoint of heat resistance of the laminate, the adhesive layer is preferably a thermoplastic polyimide.

The glass transition temperature of the thermoplastic polyimide is preferably 300°C or less, more preferably 280°C or less, and further preferably 260°C or less. When the glass transition temperature is 300°C or less, sufficient adhesiveness can be developed, for example, when heat roll laminating is performed in a step of pasting the metal layer to the layer including the polyimide resin.

[Production Method of Laminate]

No particular limitation is imposed on the production method of the laminate, and the production method of the laminate can be appropriately selected in accordance with the intended purpose. Examples of the production method of the laminate include, for example, a method including a step of pasting the metal layer to the layer including the polyimide resin via the adhesive layer; and a method of directly forming the polyimide film over the metal layer.

Examples of the method of pasting the metal layer to the layer including the polyimide resin include, for example, a method using a heat roll laminating device including one or more pairs of metal rollers; and a method using a continuous process by means of a double belt press. Of these, a method using a heat roll laminating device including one or more pairs

of metal rollers is preferably used because the device configuration is simple, which is advantageous in terms of maintenance cost.

(Substrate for Circuit)

The substrate for the circuit of the present disclosure includes the laminate of the present disclosure, and if necessary, may further include other members.

When the metal layer in the laminate is etched to form desired patterned interconnects, the substrate for the circuit is suitably used as various flexible printed circuits on which miniaturized and highly densified components are to be mounted. The application of the present invention is not limited to this, and the laminate including the metal layer can be used for various applications.

(Antenna)

The antenna of the present disclosure includes the substrate for the circuit of the present disclosure, and if necessary, may further include other members.

The polyimide resin of the present disclosure can have both a low dielectric constant and a low linear expansion coefficient, and thus is suitably used for a communication antenna.

## EXAMPLES

Hereinafter, the present invention will be described in more detail by way of Examples below, but the present invention is not limited to the Examples.

<Molecular Dynamics Simulation of Polyimide>

Molecular dynamics simulation was performed on a homopolymer having a specific structural unit, thereby calculating the free volume fraction and the average neighboring atom number in an amorphous state.

Specifically, in steps S 1 to S3 below, using the automatic polymer property calculation system, RadonPy (open source software) in an appropriate computing device (including an input device, an output device, a CPU, a memory, and the like), the structure in the equilibrium state was obtained, and the free volume fraction was calculated from the structure in the equilibrium state. In addition, an original Python program was used to calculate the average neighboring atom number from the structure in the equilibrium state by a method using a Voronoi diagram.

Specifically, a total of about 250 types of polyimides having, for example, the structures described in PolyInfo (https://polymer.nims.go.jp/) and PI1M (Reference 3: Ruimin Ma and Tengfei Luo, J. Chem. Inf. Model., 60, 10 (2020)) were used for the calculation for performing molecular dynamics simulation for each of the polyimides.

-Step S1

Data of an amorphous system was obtained for the polyimide, i.e., the homopolymer having a specific structural unit. The system constructed was a system in which 10 molecules of the polyimide having about 1,000 atoms per molecule (specifically, atoms of 900 or more and 1,100 or less) were arranged. The system in which the polyimides were aggregated was decreased in temperature from 800 K to 300 K at a pressure of 1 atm. The decrease in temperature was performed at a temperature decrease rate of 150 ps/K. Thus, data of the initial structure in the amorphous system was obtained.

The force field developed in Reference 4 below was employed for nonpreparatory calculation, and non-binding and binding interaction parameters were specified.

Reference 4:

J. Trag and D. Zahn, Improved GAFF2 Parameters for Fluorinated Alkanes and Mixed Hydro- and Fluorocarbons, J. Mol. Model. 25, 39 (2019).

-Step S2

Subsequently, the motion of each atom at a temperature of 300 K and a pressure of 1 atm was calculated through molecular dynamics simulation. The coordinates of each atom in a system of the equilibrium state at 500 ns were obtained.

<Calculation of Free Volume Fraction through Molecular Dynamics Simulation>

-Step S3-1

Subsequently, based on the coordinates of each atom at the final point in time, the free volume fraction f was calculated using the automatic polymer property calculation system, RadonPy. The free volume fraction was derived from formula 3 below. For the van der Waals radius of each atom in the formula 3 below, a value calculated based on the GAFF2 force field (Reference 1 above) was used.
(Formula 3)

[Math. 7]

$$f = (v - v_o)/v$$
$$v_o = 1.3 v_{vdw}$$
$$v_{vdw} = \sum_i \left( \frac{4}{3}\pi r_i^3 - \sum_j \frac{1}{3}\pi h_{ij}^2 (3r_i - h_{ij}) \right)$$
$$h_{ij} = \frac{r_j^2 - (r_i - d_{ij})^2}{2d_{ij}}$$

f: Free volume fraction of amorphous system
v: Volume of amorphous system
$v_o$: Occupied volume of polymer in amorphous system
$v_{vdw}$: van der Waals volume of polymer in amorphous system
$r_i$: van der Waals radius of atom i
$r_j$: van der Waals radius of atom j bonded to atom i
$d_{ij}$: Distance between atom i and atom j

<Calculation of Average Neighboring Atom Number through Molecular Dynamics Simulation>

-Step S3-2

Subsequently, based on the coordinates of each atom at the final point in time, the average neighboring atom number in the system was calculated by the following method.
Specifically, the number of neighboring atoms was calculated as the total number of atom pairs satisfying (a) and (b) below:

(a) in a Voronoi diagram calculated with each atom serving as a site, the atom pairs each have a shared Voronoi side (a pair of sites), and
(b) the atom pairs are each a pair of atoms 4 bonds or more away from each other, or a pair of atoms existing in different molecules.

Next, the average neighboring atom number was calculated by dividing the total number of pairs satisfying (a) and (b) above (i.e., the number of neighboring atoms) in a system having a periodic boundary condition, by the number of atoms constituting the system.

<Calculation of Dielectric Constant at Frequency of 10 GHz through Molecular Dynamics Simulation>

In accordance with the following procedure, time-series data of the dipole moment of the polyimide was calculated, and, based on the time-series data equal to or higher than a frequency of 10 GHz, the dielectric constant at a frequency of 10 GHz was calculated.
Specifically, through molecular dynamics calculation, the length of a dielectric relaxation function was set to 100 ns, and the time length for calculating a dipole moment was set to 500 ns, and the dipole moment of a target substance was calculated. Thus, the time-series data of the dipole moment is generated.
Next, based on received calculation conditions, a high-pass filter was designed. The cutoff frequency of the high-pass filter was a reciprocal of the length of the dielectric relaxation function. Because the length of the dielectric relaxation function was set to 100 ns, the cutoff frequency was set to 10 MHz.

Next, the designed high-pass filter was used to remove low-frequency components from the time-series data of the dipole moment. In other words, the frequency band equal to or higher than the cutoff frequency of 10 MHz or more was extracted from the time-series data of the dipole moment. This generates time-series data of the dipole moment after filtering, in which the low-frequency components less than 10 MHz were removed.

Next, the time-series data of the dipole moment after filtering was used as M(t), and a dielectric relaxation function Φ(t) was calculated according to formula (1). Fitting of the calculated dielectric relaxation function Φ(t) in formula (2) was performed. Further, the dielectric relaxation function $\Phi_{fit}(t)$ after fitting was frequency-resolved by a Fourier transform of formula (3). Thus, a frequency-dependent complex dielectric constant was obtained. The dielectric constant at a frequency of 10 GHz was determined by the real part of the complex dielectric constant at a frequency of 10 GHz.

[Math. 8]

$$\Phi(t) = \frac{\langle \mathrm{M}(t) \cdot \mathrm{M}(0) \rangle - \langle \mathrm{M} \rangle^2}{\langle \mathrm{M}(0)^2 \rangle - \langle \mathrm{M} \rangle^2} \quad \ldots (1)$$

[Math. 9]

$$\Phi_{fit}(t) = A\exp\left[-\left(\frac{t}{10^{\alpha_1}}\right)^{\beta_1}\right] + (1-A)\exp\left[-\left(\frac{t}{10^{\alpha_2}}\right)^{\beta_2}\right] \quad \ldots (2)$$

[Math. 10]

$$\frac{\varepsilon^*(i\omega) - \varepsilon_\infty}{\Delta\varepsilon} = \int_0^\infty dt \left[-\frac{d\Phi_{fit}(t)}{dt}\right] \exp(-i\omega t) \quad \ldots (3)$$

<Calculation of Linear Expansion Coefficient through Molecular Dynamics Simulation>

First, based on a volume V and a fluctuation in an enthalpy H in equilibrium calculation, a volume expansion rate $\alpha_P$ was calculated according to a formula below. $k_B$ represents the Boltzmann constant, and T represents a temperature.

[Math. 11]

$$\alpha_P = \frac{\langle \delta V \delta H \rangle}{k_B T^2 \langle V \rangle}$$

Next, assuming the isotropy of a system, a linear expansion coefficient $\alpha_L$ was derived according to a formula below.

[Math. 12]

$$\alpha_L = \frac{1}{3}\alpha_P$$

FIG. 3 is a graph in which the free volume fractions and the average neighboring atom numbers are plotted. In FIG. 3, the black dots indicate that the linear expansion coefficient and the dielectric constant calculated through molecular dynamics simulation are 55 ppm/K or less and 2.4 or less, respectively.

FIG. 4 is a graph in which measured values of the dielectric constant and the linear expansion coefficient of various polymers are plotted. Note that the measured values are the values described in PolyInfo.

FIG. 4 suggests that there is generally a negative correlation (correlation coefficient: -0.74) between these two

physical properties, and this indicates difficulty in achieving both a low linear expansion coefficient and a low dielectric constant.

Then, when visualizing the polyimides (black dots) having both a low linear expansion coefficient and a low dielectric constant in FIG. 3, it has been found that polyimides having both a low dielectric constant and a low linear expansion coefficient exist in a region having a high free volume fraction and a small average neighboring atom number.

Specifically, it has been found that both a low dielectric constant and a low linear expansion coefficient can be achieved when the free volume fraction and the average neighboring atom number satisfy the condition (1):

(1) the free volume fraction is 0.23 to 0.32 and the average neighboring atom number is 3.90 to 4.60, and no trifluoromethyl group is included.

Here, a reason why polyimides having a high free volume fraction, i.e., 0.23 or more, exhibit properties of a low dielectric constant and a low linear expansion coefficient is as follows.

Specifically, polyimides having a high free volume fraction have a rigid or bulky structure as a characteristic of their molecular structure. In the amorphous state, polyimides having a rigid molecular structure maintain the shape of the molecular chain to be in a rod-like shape regardless of the surrounding molecular arrangement. Therefore, such polyimides are considered to have a loose structure as a result of difficulty in being packed with high density caused by virtue of a flexible structural change of the molecular chain. Also, polyimides having a bulky molecular structure are that their bulky moiety is a steric hindrance and inhibits free internal rotation of the molecular chain. Therefore, such polyimides are considered to have a loose structure as a result of suppression in being packed with high density caused by virtue of a flexible structural change of the molecular chain. The loose structure is smaller than a dense structure in terms of polarization per volume. Thus, the loose structure decreases in responsiveness to an electric field, and contributes to reduction in dielectric constant. Therefore, polyimides having a high free volume fraction, characterized by a rigid or bulky molecular structure, are considered to have a low dielectric constant.

Also, polyimides having a rigid or bulky structure are presumed to experience inhibition of internal rotation of the molecular chain for the above reasons. Such polyimides are considered to have a small change in molecular mobility (change in frequency of conformational rotation) caused by thermal energy. The small change in molecular mobility caused by thermal energy means that the change in free volume with respect to the change in temperature is small. Hence, this means a material having a low thermal expansion rate, i.e., a low thermal expansion coefficient. Therefore, polyimides having a high free volume fraction, characterized by a rigid or bulky molecular structure, are considered to have a low thermal expansion coefficient.

For the above reasons, the high free volume fraction, i.e., a value of 0.23 or more, contributes to a low dielectric constant and a low linear expansion coefficient.

Polyimides having a small average neighboring atom number, i.e., 4.95 or less, are polyimides including sp3 hybridized carbon atoms at a high rate. Such polyimides are, for example, polyimides having an aliphatic or alicyclic structure. The sp3 hybridized carbon atom is surrounded by bonded atoms, and thus there is a low probability that the sp3 hybridized carbon atom will contact a non-bonded atom. The average neighboring atom number represents an average number of non-bonded atoms existing around each atom. Thus, a higher rate of the included sp3 hybridized carbon atoms results in a smaller value of the average neighboring atom number.

On the other hand, aromatic polyimides including a large number of sp2 hybridized carbon atoms tend to exhibit a relatively high dielectric constant because the contribution of $\pi$ electrons having high polarizability is included in the dielectric constant. Therefore, as the ratio of the sp3 hybridized carbon atoms to the sp2 hybridized carbon atoms becomes higher, the contribution of $\pi$ electrons becomes smaller, i.e., the dielectric constant decreases. Therefore, the small average neighboring atom number, i.e., 4.95 or less, contributes to a low dielectric constant.

As described above, it has been found that the high free volume fraction contributes to a low dielectric constant and a low linear expansion coefficient, and the small average neighboring atom number contributes to a low dielectric constant. Therefore, polyimides having the high free volume fraction and the small average neighboring atom number satisfying the above condition (1) have both a low dielectric constant and a low linear expansion coefficient.

<Comparison between Experimental Values and Calculated Values in Molecular Dynamics Simulation>

For the properties of polyimides, i.e., the dielectric constant at a frequency of 10 GHz and the linear expansion coefficient, the experimental values of polyimides having publicly known experimental values were compared with the calculated values in molecular dynamics simulation. The results are shown in FIGS. 5 and 6.

Specifically, the polyimides having publicly known experimental values were polymers described in PolyInfo and Reference 5 below.

Reference 5:

J.O. Simpson and A.K. St. Clair, Thin Solid Films, 308-309 (1997)

FIG. 5 is a graph indicating a relationship between the experimental values and the calculated values in the molecular dynamics simulation for the dielectric constant at a frequency of 10 GHz. FIG. 6 is a graph indicating a relationship between the experimental values and the calculated values in the molecular dynamics simulation for the linear expansion coefficient.

In FIGS. 5 and 6, each dot indicates a polymer having a publicly known experimental value that was subjected to molecular dynamics simulation. The horizontal axis indicates the experimental values, and the vertical axis indicates the calculated values. Correlation coefficients are 0.94 (FIG. 5) and 0.91 (FIG. 6), indicating positive correlations in both physical properties.

It has been found from FIGS. 5 and 6 that values of the physical properties, i.e., the dielectric constant and the linear expansion coefficient obtained through the molecular dynamics simulation represent the experimental values qualitatively.

From the above, the two parameters that can reflect a low dielectric constant and a low linear expansion coefficient (calculated values), i.e., the free volume fraction and the average neighboring atom number, are effective parameters for material design in which the dielectric constant and the linear expansion coefficient are intended physical properties.

(Synthesis Example 1)

3.5 g of 2,3,5,6-tetramethyl-1,4-phenylenediamine (TMPD), 4.8 g of 1,2,4,5-cyclohexanetetracarboxylic dianhydride (HPMDA), and N-methyl-2-pyrrolidone (NMP) were added to a flask, followed by stirring at 25°C for 96 hours, thereby synthesizing a polyamic acid. The obtained polyamic acid A had a Mw of 7,000.

[Chem. 33]

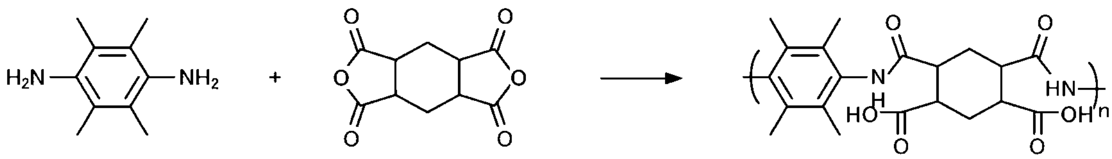

TMPD HPMDA Polyamic acid A

(Synthesis Example 2)

In a nitrogen atmosphere, 1.0 g of 2,4,6-trimethylbenzene-1,3-diamine, 5.9 mL of γ-butyrolactone, 1.5 g of N-ethylpiperidine, and 1.49 g of hexahydro-1H,3H-benzo[1,2-c: 4,5-c']difuran-1,3,5,7-tetraone were added to a recovery flask, followed by stirring at 160°C to 215°C for 4 hours. Subsequently, the resulting mixture was allowed to cool, followed by recrystallization from acetone, thereby obtaining 1.9 g of powder. The obtained powder was subjected to IR measurement, and as a result, peaks corresponding to C=O and C=N characteristic to an imide group were confirmed. Therefore, it was confirmed that, in accordance with the following reaction formula, the corresponding polyimide was obtained.

[Chem. 34]

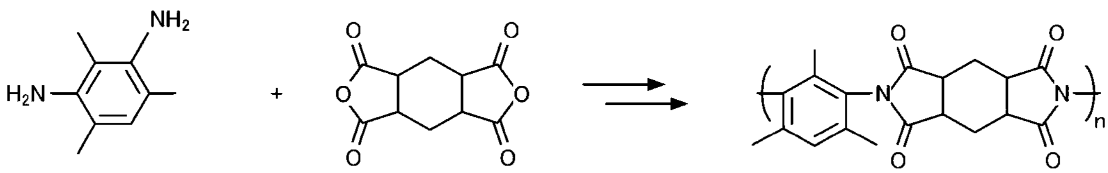

<Evaluation>

The linear expansion coefficient at 20°C to 200°C and the relative dielectric constant of the polyimide obtained in

Synthesis Example 2 were evaluated in accordance with the following procedure.

<<Linear Expansion Coefficient>>

First, as a sample, the obtained polyimide was used to form a sheet having an average thickness of 25 μm. Using a thermomechanical analyzer (EXSTAR6000TMA/SS6000, obtained from SII Nanotechnology), the linear expansion coefficient at 20°C to 200°C of the polyimide was measured, and then evaluated, under the following measurement conditions.

--Measurement Conditions--

First step: Increasing the temperature to 150°C at a temperature increase rate of 5°C/min to remove adsorbed water from the sample.
Second step: Cooling the sample in air to room temperature at a temperature decrease rate of 5°C/min.
Third step: Performing nonpreparatory measurement of the sample at a temperature increase rate of 5°C/min.
The average value of the linear expansion coefficients in a temperature range of 20°C to 200°C in the nonpreparatory measurement was determined as an intended linear expansion coefficient of the polyimide.
Evaluation of "the linear expansion coefficient at 20°C to 200°C of the polyimide" was performed in accordance with the following evaluation criteria.

-Evaluation Criteria-

Good: The linear expansion coefficient of the polyimide is 50 ppm/°C or less.
Bad: The linear expansion coefficient of the polyimide is more than 50 ppm/°C.

<<Relative Dielectric Constant>>

As a sample, the obtained polyimide was used to form a sheet having an average thickness of 25 μm. Using a vector network analyzer (E5063A, obtained from Keysight), the relative dielectric constant of the polyimide was measured through SPDR (resonator method) at 25°C and 10 GHz. Evaluation was performed in accordance with the following evaluation criteria.

-Evaluation Criteria-

Good: The relative dielectric constant of the polyimide is 2.6 or less.
Bad: The relative dielectric constant of the polyimide is more than 2.6.

As a result of evaluating the polyimide obtained in Synthetic Example 2, it was confirmed that the linear expansion coefficient at 20°C to 200°C was evaluated as "Good" and the relative dielectric constant of the polyimide was evaluated as "Good".
Although the embodiments have been described above, it should be understood that various modifications of the form and details are possible without departing from the intent and scope of claims recited.
This application claims priority to Japanese Patent Application No. 2024-070590, filed on April 24, 2024, and the entire contents of Japanese Patent Application No. 2024-070590 are incorporated into the present international application by reference.

REFERENCE SIGNS LIST

1 Polyimide film
2 Adhesive layer
3 Metal layer
10 Laminate

20 Laminate

**Claims**

1. A polyimide resin for a substrate material, the polyimide resin comprising:

an acid anhydride; and
a diamine, wherein
the acid anhydride is one or more selected from the group consisting of compounds represented by general formula (A-1a) below, and
the diamine is one or more selected from the group consisting of compounds represented by general formula (B-1) below and compounds represented by general formula (B-2) below:

[Chem. 1]

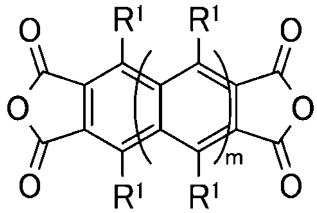

A-1a

in the general formula (A-1a),

$R^1$ is each independently selected from the group consisting of hydrogen, halogens, optionally substituted alkyl groups, optionally substituted aromatic rings, and optionally substituted heterocyclic rings,
at least one $R^1$ includes a fluorine atom, and
m represents an integer of 0 to 3,

[Chem. 2]

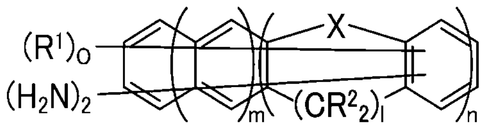

B-1

in the general formula (B-1),

$R^1$ is each independently selected from the group consisting of hydrogen, halogens, optionally substituted alkyl groups, optionally substituted alkoxy groups, optionally substituted aromatic rings, and optionally substituted heterocyclic rings,
l represents an integer of 1 to 3,
m represents an integer of 0 to 3,
n represents an integer of 0 to 5,
o represents an integer of 0 to a maximum substituent number,
$R^2$ is each independently selected from the group consisting of hydrogen, halogens, optionally substituted alkyl groups, optionally substituted aromatic rings, and optionally substituted heterocyclic rings, where two neighboring $R^2$ are optionally bonded to form a cycloalkyl group,
at least one $R^2$ is an optionally substituted fluoroalkyl group,
X is each independently selected from the group consisting of -O-, -$C(R^3)_2$-, and -$SO_2$-, and
$R^3$ is each independently selected from the group consisting of hydrogen, halogens, optionally substituted alkyl groups, optionally substituted aromatic rings, and optionally substituted heterocyclic rings,

where two neighboring $R^3$ are optionally bonded to form a cycloalkyl group, and

[Chem. 3]

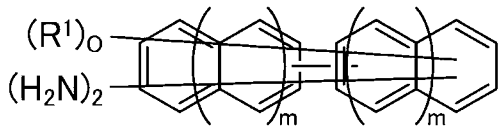

B-2

in the general formula (B-2),

$R^1$ is each independently selected from the group consisting of hydrogen, halogens, optionally substituted alkyl groups, optionally substituted alkoxy groups, optionally substituted aromatic rings, and optionally substituted heterocyclic rings,
at least one $R^1$ includes a fluorine atom,
m each independently represents an integer of 0 to 2, and
o represents an integer of 0 to a maximum substituent number.

**2.** The polyimide resin according to claim 1, wherein

the general formula (B-1) is general formula (B-1a) below or general formula (B-1b) below, and
the general formula (B-2) is general formula (B-2a) below:

[Chem. 4]

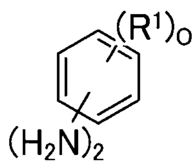

B-1a

in the general formula (B-1a),

$R^1$ is each independently selected from the group consisting of hydrogen, halogens, optionally substituted alkyl groups, optionally substituted alkoxy groups, optionally substituted aromatic rings, and optionally substituted heterocyclic rings, and
o represents an integer of 0 to 4,

[Chem. 5]

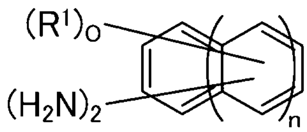

B-1b

in the general formula (B-1b),

$R^1$ is each independently selected from the group consisting of hydrogen, halogens, optionally substituted alkyl groups, optionally substituted alkoxy groups, optionally substituted aromatic rings, and optionally substituted heterocyclic rings,
m represents an integer of 1 to 3, and
o represents an integer of 0 to a maximum substituent number, and

[Chem. 6]

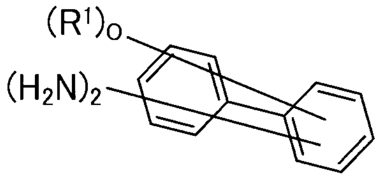

B-2a

in the general formula (B-2a),

$R^1$ is each independently selected from the group consisting of hydrogen, halogens, optionally substituted alkyl groups, optionally substituted alkoxy groups, optionally substituted aromatic rings, and optionally substituted heterocyclic rings,
at least one $R^1$ includes a fluorine atom, and
o represents an integer of 0 to 8.

**3.** A polyimide resin for a substrate material, the polyimide resin comprising:

an acid anhydride; and
a diamine, wherein
the acid anhydride is one or more selected from the group consisting of compounds represented by general formula (A-2a) to general formula (A-2g) below, and
the diamine is one or more selected from the group consisting of compounds represented by general formula (B-3) below and compounds represented by general formula (B-4) below:

[Chem. 7]

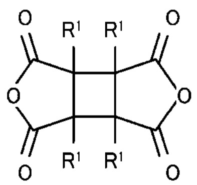

A-2a

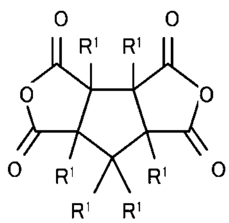

A-2b

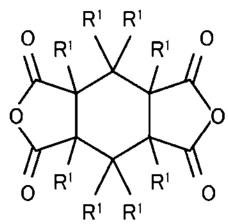

A-2c

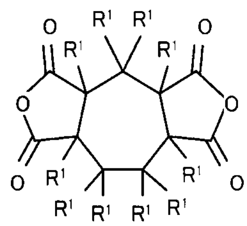

A-2d

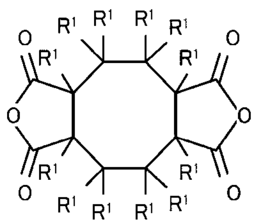

A-2e

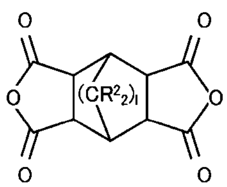

A-2f

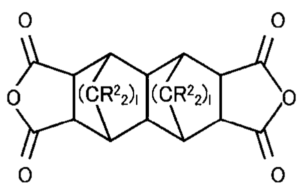

A-2g

in the general formula (A-2a) to the general formula (A-2g),

$R^1$ is each independently selected from the group consisting of hydrogen, halogens, optionally substituted alkyl groups, optionally substituted alkoxy groups, optionally substituted aromatic rings, and optionally substituted heterocyclic rings,
l represents an integer of 1 to 3, and
$R^2$ is each independently selected from the group consisting of hydrogen, halogens, optionally substituted alkyl groups, optionally substituted alkoxy groups, optionally substituted aromatic rings, and optionally substituted heterocyclic rings,

[Chem. 8]

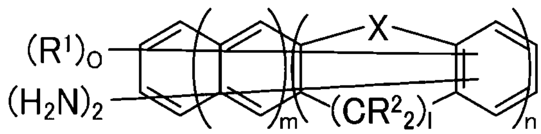

B-3

in the general formula (B-3),

$R^1$ is each independently selected from the group consisting of hydrogen, halogens, optionally substituted alkyl groups, optionally substituted alkoxy groups, optionally substituted aromatic rings, and optionally substituted heterocyclic rings,
l represents an integer of 1 to 3,
m represents an integer of 0 to 3,
n represents an integer of 0 to 5,
o represents an integer of 0 to a maximum substituent number,
$R^2$ is each independently selected from the group consisting of hydrogen, halogens, optionally substituted alkyl groups, optionally substituted aromatic rings, and optionally substituted heterocyclic rings,
at least one $R^2$ is an optionally substituted fluoroalkyl group,
X is each independently selected from the group consisting of -O-, $-C(R^3)_2-$, and $-SO_2-$, and
$R^3$ is each independently selected from the group consisting of hydrogen, halogens, optionally substituted alkyl groups, optionally substituted aromatic rings, and optionally substituted heterocyclic rings, where two neighboring $R^3$ are optionally bonded to form a cycloalkyl group,

[Chem. 9]

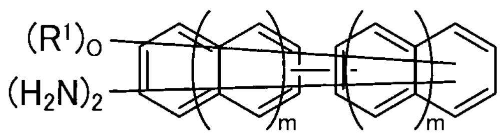

B-4

in the general formula (B-4),

$R^1$ is each independently selected from the group consisting of hydrogen, halogens, optionally substituted alkyl groups, optionally substituted alkoxy groups, optionally substituted aromatic rings, and optionally substituted heterocyclic rings,
m each independently represents an integer of 0 to 2, and
o represents an integer of 0 to a maximum substituent number.

**4.** The polyimide resin according to claim 3, wherein

the general formula (B-3) is general formula (B-3a) below or general formula (B-3b) below, and
the general formula (B-4) is general formula (B-4a) below:

[Chem. 10]

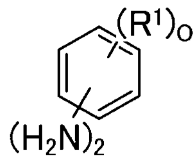

B−3a

in the general formula (B-3a),

$R^1$ is each independently selected from the group consisting of hydrogen, halogens, optionally substituted alkyl groups, optionally substituted alkoxy groups, optionally substituted aromatic rings, and optionally substituted heterocyclic rings, and
o represents an integer of 0 to 4,

[Chem. 11]

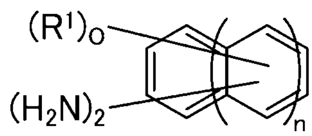

B−3b

in the general formula (B-3b),

$R^1$ is each independently selected from the group consisting of hydrogen, halogens, optionally substituted alkyl groups, optionally substituted alkoxy groups, optionally substituted aromatic rings, and optionally substituted heterocyclic rings,
m represents an integer of 1 to 3, and
o represents an integer of 0 to a maximum substituent number, and

[Chem. 12]

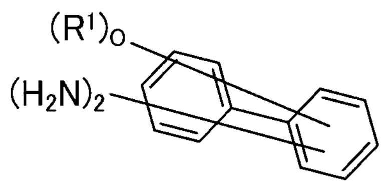

B−4a

in the general formula (B-4a),

$R^1$ is each independently selected from the group consisting of hydrogen, halogens, optionally substituted alkyl groups, optionally substituted alkoxy groups, optionally substituted aromatic rings, and optionally substituted heterocyclic rings,
at least one $R^1$ includes a fluorine atom, and
o represents an integer of 0 to 8.

**5.** The polyimide resin according to any one of claims 1 to 4, wherein

a dielectric constant at 10 GHz of the polyimide resin is 2.5 or less, and
a linear expansion coefficient of the polyimide resin is 40 ppm/K or less.

**6.** A polyimide resin for a substrate material, the polyimide resin comprising:

a structural unit of general formula (1) below:

[Chem. 13]

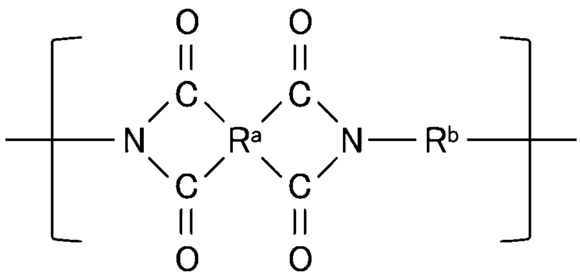

General Formula (1)

in the general formula (1),

an $R^a(CO)_4$ moiety represents a tetravalent group derived from a tetravalent tetracarboxylic acid having 2 or more carbon atoms, and
an $R^b(N)_2$ moiety represents a tetravalent group derived from a divalent diamine having 2 or more carbon atoms, wherein

a free volume fraction and an average neighboring atom number of the polyimide resin in an amorphous state that are calculated through molecular dynamics calculation in an equilibrium state in which a temperature is 300 K and a pressure is 1 atm, satisfy condition (1) below:

(1) the free volume fraction is 0.23 to 0.32 and the average neighboring atom number is 3.90 to 4.60, and no trifluoromethyl group is included,

the average neighboring atom number is an average of a number of neighboring atoms per a number of atoms constituting a system of the molecular dynamics calculation, and
the number of neighboring atoms is a total number of atom pairs satisfying (a) and (b) below:

(a) the atom pairs each have one shared side of Voronoi cells in which the atoms are sites, and
(b) the atom pairs are each a pair of atoms 4 bonds or more away from each other, or a pair of atoms existing in different molecules.

**7.** The polyimide resin according to claim 6, wherein

the free volume fraction is 0.24 to 0.32, and the average neighboring atom number is 3.90 to 4.50, and
the polyimide resin includes no trifluoromethyl group.

**8.** The polyimide resin according to claim 6, wherein

the free volume fraction is 0.28 to 0.32, and the average neighboring atom number is 3.90 to 4.50, and the polyimide resin includes no trifluoromethyl group.

**9.** The polyimide resin according to any one of claims 1 to 8, wherein

a free volume fraction and an average neighboring atom number of the polyimide resin in an amorphous state that are calculated through molecular dynamics calculation in an equilibrium state in which a temperature is 300 K and a pressure is 1 atm, satisfy condition (1) below:

(1) the free volume fraction is 0.23 to 0.32 and the average neighboring atom number is 3.90 to 4.60, and no trifluoromethyl group is included,

the average neighboring atom number is an average of a number of neighboring atoms per one molecule of the polyimide resin,
the average neighboring atom number is an average of a number of neighboring atoms per a number of atoms constituting a system of the molecular dynamics calculation, and
the number of neighboring atoms is a total number of atom pairs satisfying (a) and (b) below:

(a) the atom pairs each have one shared side of Voronoi cells in which the atoms are sites, and
(b) the atom pairs are each a pair of atoms 4 bonds or more away from each other, or a pair of atoms existing in different molecules.

**10.** A composition for a substrate material, the composition comprising:
the polyimide resin of any one of claims 1 to 9.

**11.** A polyimide film for a substrate material, the polyimide film comprising:
the polyimide resin of any one of claims 1 to 9.

**12.** A laminate, comprising:

a metal layer; and
a layer including the polyimide resin of any one of claims 1 to 9.

**13.** A substrate for a circuit, the substrate comprising:
the laminate of claim 12.

**14.** An antenna, comprising:
the substrate for the circuit of claim 13.

**15.** A polyamic acid for a substrate material, the polyamic acid comprising:

an acid anhydride; and
a diamine, wherein
the acid anhydride is one or more selected from the group consisting of compounds represented by general formula (A-1a) below, and
the diamine is one or more selected from the group consisting of compounds represented by general formula (B-1) below and compounds represented by general formula (B-2) below:

[Chem. 14]

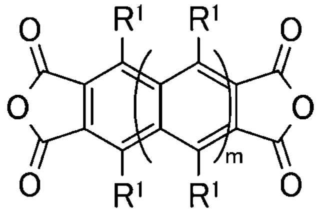

A-1a

in the general formula (A-1a),

$R^1$ is each independently selected from the group consisting of hydrogen, halogens, optionally substituted alkyl groups, optionally substituted aromatic rings, and optionally substituted heterocyclic rings,
at least one $R^1$ includes a fluorine atom, and
m represents an integer of 0 to 3,

[Chem. 15]

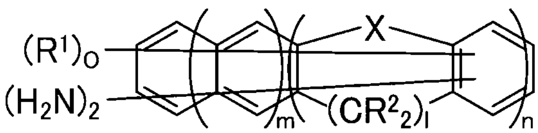

B-1

in the general formula (B-1),

$R^1$ is each independently selected from the group consisting of hydrogen, halogens, optionally substituted alkyl groups, optionally substituted aromatic rings, and optionally substituted heterocyclic rings,
l represents an integer of 1 to 3,
m represents an integer of 0 to 3,
n represents an integer of 0 to 5,
o represents an integer of 0 to a maximum substituent number,
$R^2$ is each independently selected from the group consisting of hydrogen, halogens, optionally substituted alkyl groups, optionally substituted aromatic rings, and optionally substituted heterocyclic rings, where two neighboring $R^2$ are optionally bonded to form a cycloalkyl group,
at least one $R^2$ is an optionally substituted fluoroalkyl group,
X is each independently selected from the group consisting of -O-, $-C(R^3)_2-$, and $-SO_2-$, and
$R^3$ is each independently selected from the group consisting of hydrogen, halogens, optionally substituted alkyl groups, optionally substituted aromatic rings, and optionally substituted heterocyclic rings, where two neighboring $R^3$ are optionally bonded to form a cycloalkyl group, and

[Chem. 16]

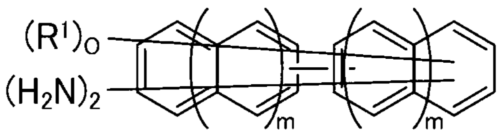

B-2

in the general formula (B-2),

$R^1$ is each independently selected from the group consisting of hydrogen, halogens, optionally substituted alkyl groups, optionally substituted aromatic rings, and optionally substituted heterocyclic rings,
at least one $R^1$ includes a fluorine atom,
m each independently represents an integer of 0 to 2, and
o represents an integer of 0 to a maximum substituent number.

**16.** A polyamic acid for a substrate material, the polyamic acid comprising:

an acid anhydride; and
a diamine, wherein
the acid anhydride is one or more selected from the group consisting of compounds represented by general formula (A-2a) to general formula (A-2g) below, and
the diamine is one or more selected from the group consisting of compounds represented by general formula (B-3) below and compounds represented by general formula (B-4) below:

[Chem. 17]

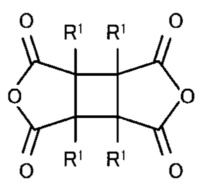
A−2a

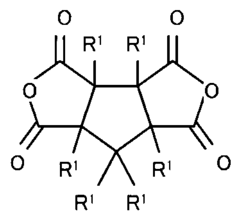
A−2b

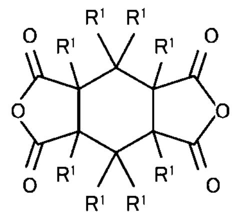
A−2c

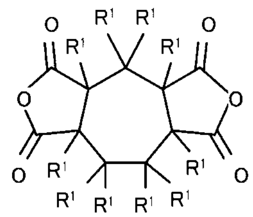
A−2d

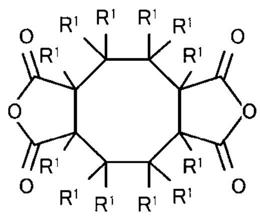
A−2e

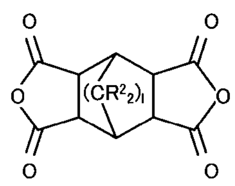
A−2f

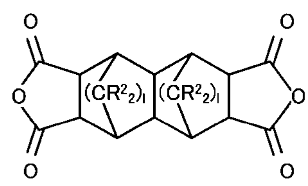
A−2g

in the general formula (A-2a) to the general formula (A-2g),

$R^1$ is each independently selected from the group consisting of hydrogen, halogens, optionally substituted alkyl groups, optionally substituted alkoxy groups, optionally substituted aromatic rings, and optionally substituted heterocyclic rings,
l represents an integer of 1 to 3, and
$R^2$ is each independently selected from the group consisting of hydrogen, halogens, optionally substituted alkyl groups, optionally substituted alkoxy groups, optionally substituted aromatic rings, and optionally substituted heterocyclic rings,

[Chem. 18]

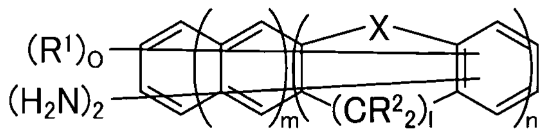

B-3

in the general formula (B-3),

$R^1$ is each independently selected from the group consisting of hydrogen, halogens, optionally substituted alkyl groups, optionally substituted alkoxy groups, optionally substituted aromatic rings, and optionally substituted heterocyclic rings,
l represents an integer of 1 to 3,
m represents an integer of 0 to 3,
n represents an integer of 0 to 5,
o represents an integer of 0 to a maximum substituent number,
$R^2$ is each independently selected from the group consisting of hydrogen, halogens, optionally substituted alkyl groups, optionally substituted aromatic rings, and optionally substituted heterocyclic rings, at least one $R^2$ is an optionally substituted fluoroalkyl group,
X is each independently selected from the group consisting of -O-, $-C(R^3)_2-$, and $-SO_2-$, and
$R^3$ is each independently selected from the group consisting of hydrogen, halogens, optionally substituted alkyl groups, optionally substituted aromatic rings, and optionally substituted heterocyclic rings, where two neighboring $R^3$ are optionally bonded to form a cycloalkyl group, and

[Chem. 19]

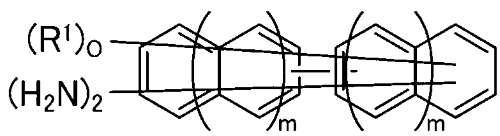

B-4

in the general formula (B-4),

$R^1$ is each independently selected from the group consisting of hydrogen, halogens, optionally substituted alkyl groups, optionally substituted alkoxy groups, optionally substituted aromatic rings, and optionally substituted heterocyclic rings,
m each independently represents an integer of 0 to 2, and
o represents an integer of 0 to a maximum substituent number.

**17.** A composition for a substrate material, the composition comprising:

the polyamic acid of claim 15 or 16; and
a solvent.

FIG.1

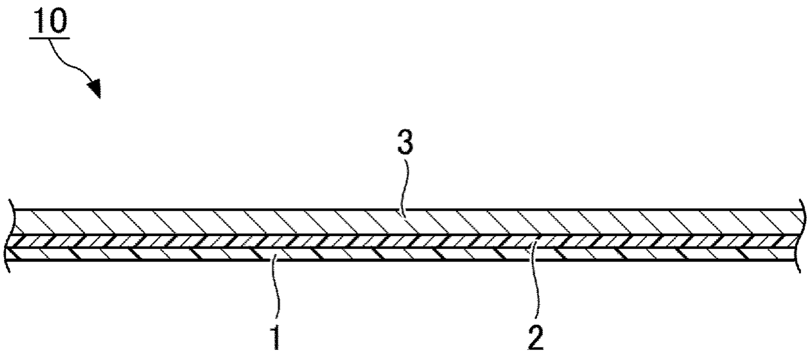


FIG.2

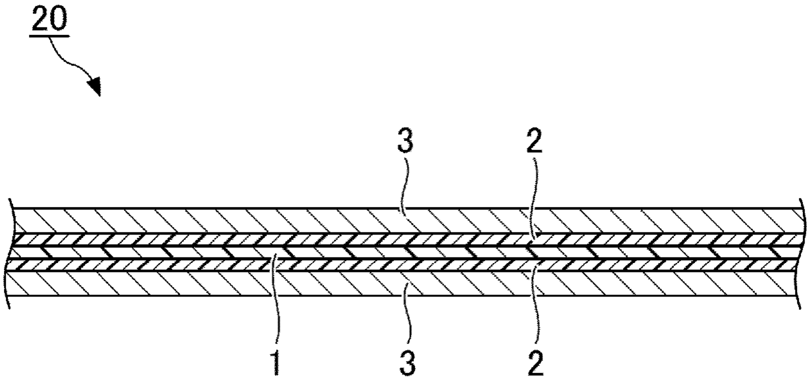

FIG.3

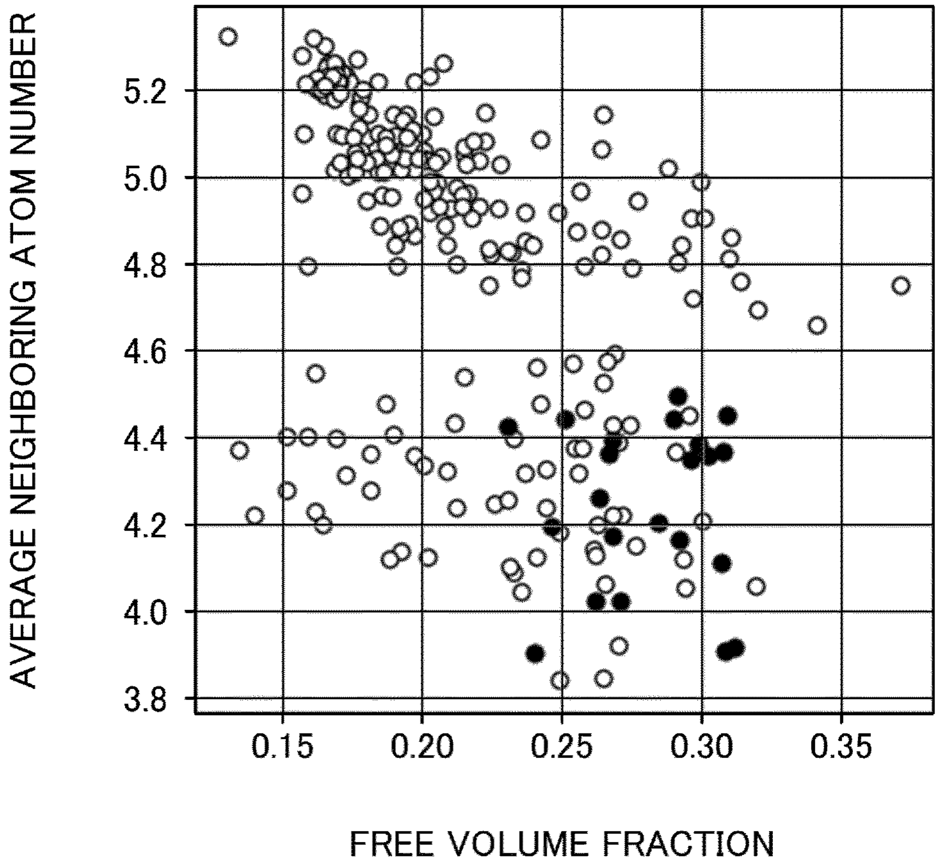
AVERAGE NEIGHBORING ATOM NUMBER
5.2
5.0
4.8
4.6
4.4
4.2
4.0
3.8
0.15
0.20
0.25
0.30
0.35
FREE VOLUME FRACTION

FIG.4

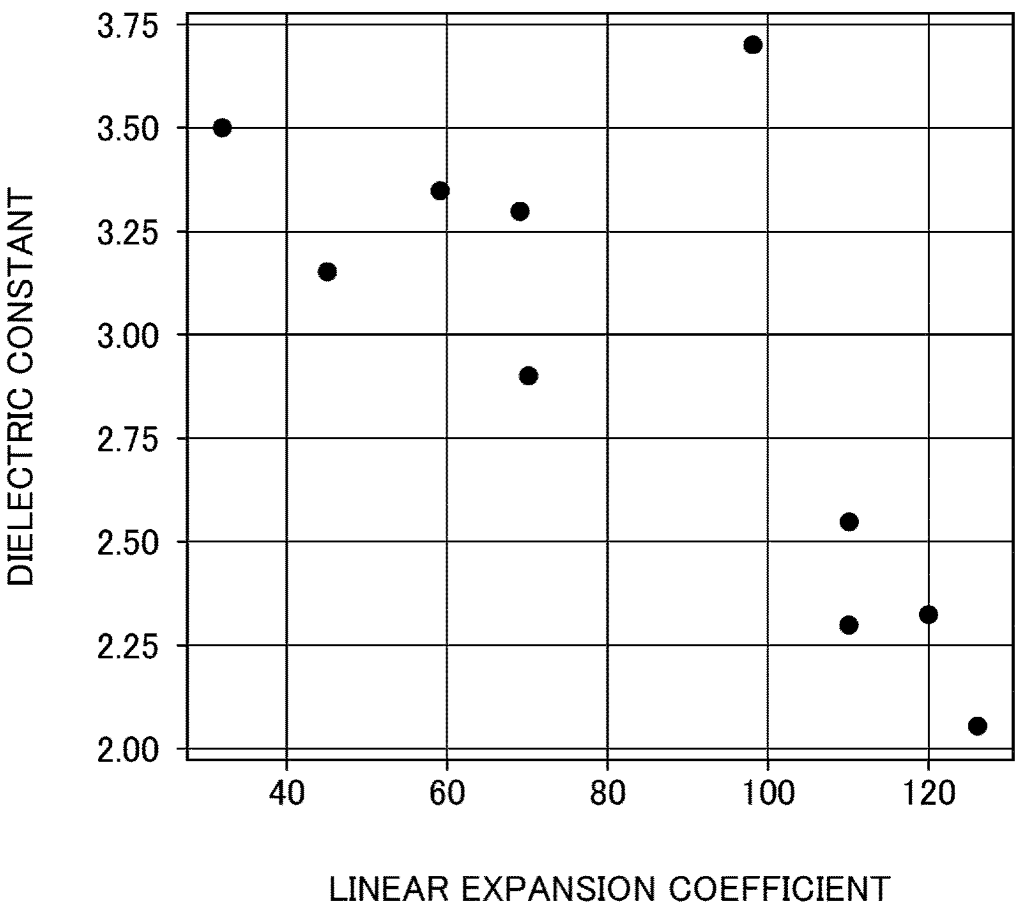
3.75
3.50
3.25
3.00
2.75
2.50
2.25
2.00
DIELECTRIC CONSTANT
40
60
80
100
120
LINEAR EXPANSION COEFFICIENT

FIG.5

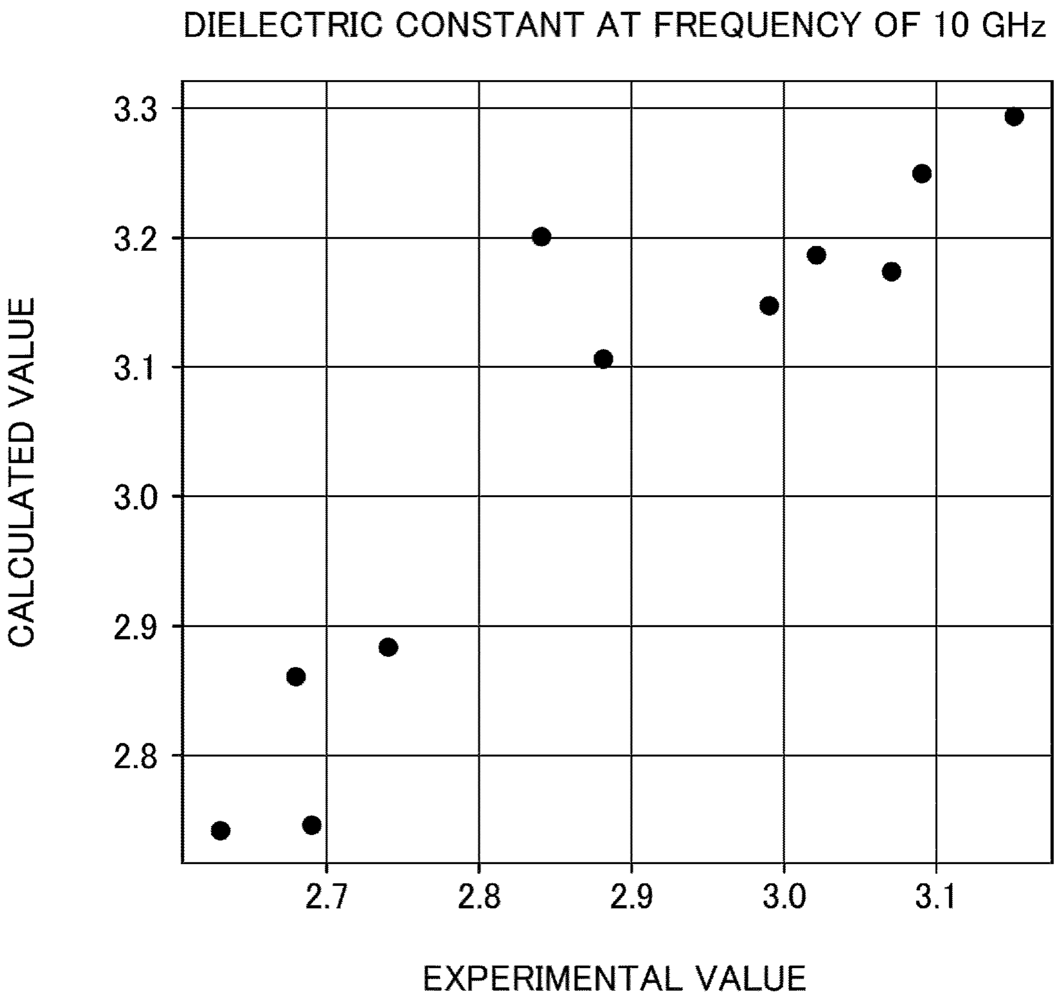
DIELECTRIC CONSTANT AT FREQUENCY OF 10 GHz
CALCULATED VALUE
3.3
3.2
3.1
3.0
2.9
2.8
2.7
2.8
2.9
3.0
3.1
EXPERIMENTAL VALUE

FIG.6

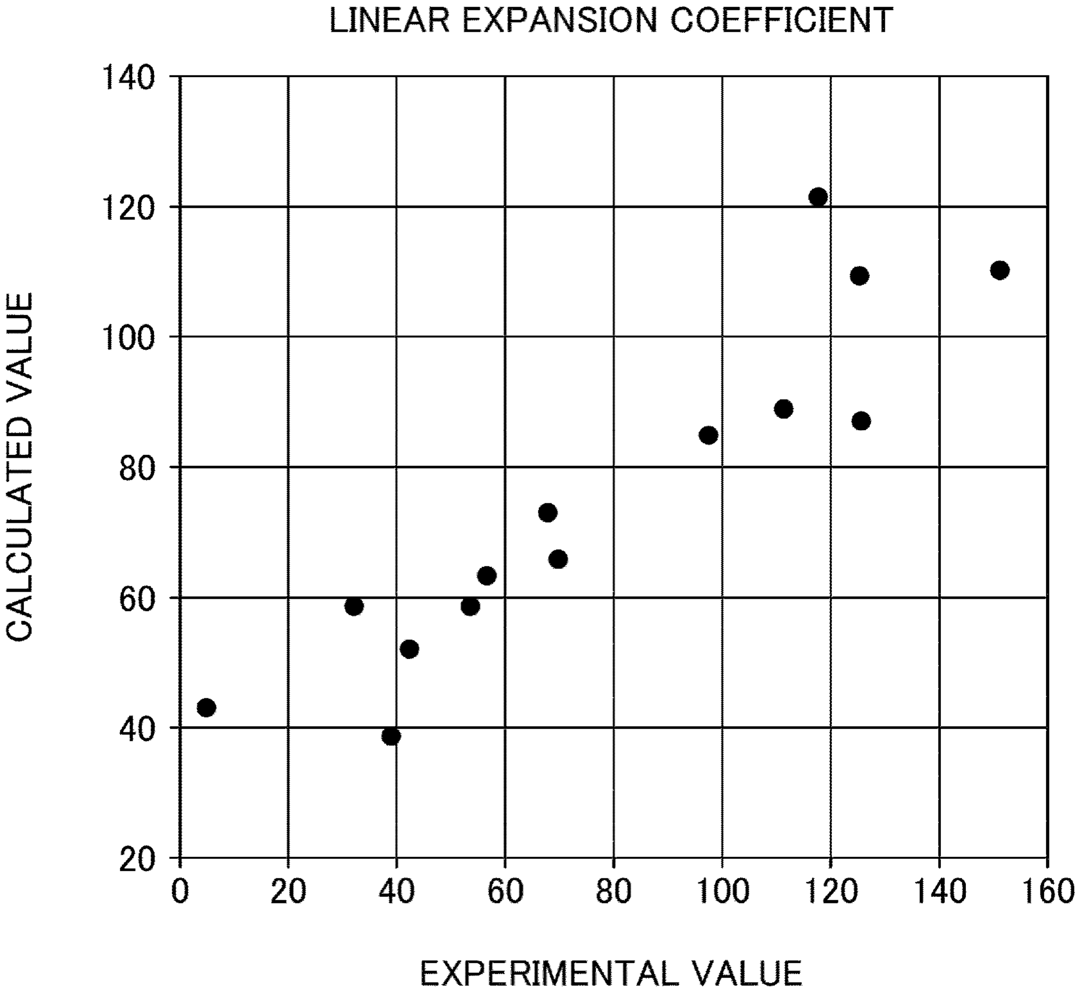
LINEAR EXPANSION COEFFICIENT
CALCULATED VALUE
EXPERIMENTAL VALUE
140
120
100
80
60
40
20
0
20
40
60
80
100
120
140
160

## INTERNATIONAL SEARCH REPORT

International application No.
**PCT/JP2025/015593**

**A. CLASSIFICATION OF SUBJECT MATTER**

***C08G 73/10***(2006.01)i; ***B32B 15/088***(2006.01)i; ***H05K 1/03***(2006.01)i
FI: C08G73/10; B32B15/088; H05K1/03 610N

According to International Patent Classification (IPC) or to both national classification and IPC

**B. FIELDS SEARCHED**

Minimum documentation searched (classification system followed by classification symbols)

C08G73/10; B32B15/088; H05K1/03

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | JP 05-114164 A (NIPPON TELEGRAPH AND TELEPHONE CORPORATION) 07 May 1993 (1993-05-07) claim 1, paragraphs [0012], [0017]-[0027], example 4 | 1-2, 5, 10-12, 15, 17 |
| A | | 3-4, 6-9, 13-14, 16 |
| X | JP 04-314731 A (NIPPON TELEGRAPH AND TELEPHONE CORPORATION) 05 November 1992 (1992-11-05) claims 1-2, paragraphs [0001], [0008], [0013]-[0026], example 1 | 1-2, 5, 10-13, 15, 17 |
| A | | 3-4, 6-9, 14, 16 |
| X | JP 2013-209498 A (TOYOBO CO., LTD.) 10 October 2013 (2013-10-10) claim 1, paragraphs [0001], [0012], [0034], [0047]-[0048], synthesis examples 1-2, paragraphs [0052]-[0053] | 3-5, 10-13, 16 |
| A | | 1-2, 6-9, 14-15, 17 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **10 July 2025** | **22 July 2025** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (July 2022)

**INTERNATIONAL SEARCH REPORT**

International application No.
**PCT/JP2025/015593**

**C. DOCUMENTS CONSIDERED TO BE RELEVANT**

| Category* | Citation of document, with indication, where appropriate, of the relevant passages | Relevant to claim No. |
|---|---|---|
| X<br>A | WO 2023/203897 A1 (TAOKA CHEMICAL CO., LTD.) 26 October 2023 (2023-10-26) paragraphs [0004]-[0005], [0072], [0082]-[0083], [0085]-[0087], reference example 4 | 6-9<br>1-5, 10-17 |
| X<br>A | WO 2020/027249 A1 (JXTG NIPPON OIL & ENERGY CORP.) 06 February 2020 (2020-02-06) claims 1-6, paragraphs [0069]-[0077], [0117], [0127]-[0235], examples 7-8, 24, 34, comparative example 4 | 6-13<br>1-5, 14-17 |
| A | JP 04-283234 A (HITACHI, LTD.) 08 October 1992 (1992-10-08) claim 1, paragraphs [0029]-[0049], example 12 | 1-17 |
| A | JP 2008-100979 A (IWATANI INDUSTRIAL GASES CORP.) 01 May 2008 (2008-05-01) claim 1, paragraphs [0233]-[0268] | 1-17 |

Form PCT/ISA/210 (second sheet) (July 2022)

**INTERNATIONAL SEARCH REPORT**
**Information on patent family members**

International application No.
**PCT/JP2025/015593**

| Patent document cited in search report | Publication date (day/month/year) | Patent family member(s) | Publication date (day/month/year) |
|---|---|---|---|
| JP 05-114164 A | 07 May 1993 | (Family: none) | |
| JP 04-314731 A | 05 November 1992 | (Family: none) | |
| JP 2013-209498 A | 10 October 2013 | (Family: none) | |
| WO 2023/203897 A1 | 26 October 2023 | (Family: none) | |
| WO 2020/027249 A1 | 06 February 2020 | US 2022/0112209 A1<br>claims 1-7, paragraphs [0070]-[0076], [0121], [0131]-[0234], examples 7-8, 24, 34, comparative example 4<br>CN 112368287 A<br>KR 10-2021-0039336 A | |
| JP 04-283234 A | 08 October 1992 | (Family: none) | |
| JP 2008-100979 A | 01 May 2008 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2019196459 A
- JP 2024070590 A


### Non-patent literature cited in the description


- **X. HE** ; **V. H. MAN** ; **W. YANG** ; **T.-S. LEE** ; **J. WANG**. A Fast and High-Quality Charge Model for the next Generation General AMBER Force Field. *J. Chem. Phys.*, 2020, vol. 153, 114502
- **M. P. ALLEN** ; **D. J. TILDESLEY**. Computer Simulation of Liquids. Clarendon Press, 1989
- **RUIMIN MA** ; **TENGFEI LUO**. *J. Chem. Inf. Model.*, 2020, vol. 60, 10
- **J. TRAG** ; **D. ZAHN**. Improved GAFF2 Parameters for Fluorinated Alkanes and Mixed Hydro- and Fluorocarbons. *J. Mol. Model.*, 2019, vol. 25, 39
- **J.O. SIMPSON** ; **A.K. ST. CLAIR**. *Thin Solid Films*, 1997, 308-309